(19) Europäisches Patentamt
European Patent Office
Office européen des brevets

(11) EP 1 281 727 A1

(12) **EUROPEAN PATENT APPLICATION**
published in accordance with Art. 158(3) EPC

(43) Date of publication:
**05.02.2003 Bulletin 2003/06**

(21) Application number: **00974953.2**

(22) Date of filing: **10.11.2000**

(51) Int Cl.⁷: **C08G 73/10**

(86) International application number:
**PCT/JP00/07984**

(87) International publication number:
**WO 01/034678 (17.05.2001 Gazette 2001/20)**

(84) Designated Contracting States:
**AT BE CH CY DE DK ES FI FR GB GR IE IT LI LU MC NL PT SE TR**

(30) Priority: **10.11.1999 JP 31932399**
**23.02.2000 JP 2000045542**
**04.04.2000 JP 2000102192**
**04.04.2000 JP 2000102193**
**04.04.2000 JP 2000102194**
**04.04.2000 JP 2000102195**
**04.04.2000 JP 2000102196**

(71) Applicant: **Kaneka Corporation**
**Osaka-shi, Osaka 530-0005 (JP)**

(72) Inventors:
- **TSUJI, Hiroyuki**
**Otsu-shi, Shiga 520-0103 (JP)**
- **KIKUCHI, Takeshi**
**Otsu-shi, Shiga 520-0104 (JP)**
- **TANAKA, Koichiro**
**Otsu-shi, Shiga 520-0103 (JP)**
- **FURUTANI, Hiroyuki**
**Takatsuki-shi, Osaka 569-1044 (JP)**

(74) Representative:
**Gille Hrabal Struck Neidlein Prop Roos**
**Patentanwälte**
**Brucknerstrasse 20**
**40593 Düsseldorf (DE)**

(54) **SOLUBLE POLYIMIDE AND COMPOSITION COMPRISING THE SAME, BONDING SHEET, ADHESIVE LAMINATED FILM FOR COVERING ACCELERATOR BEAM TUBE, AND ADHESIVE LAMINATED FILM FOR COVERING CONDUCTOR WIRE FOR ACCELERATOR QUENCH HEATER**

(57) An object of the present invention relates to a soluble polyimide having an excellent heat resistance and low water absorption, a composition containing the soluble polyimide, which is cured at a relatively low temperature and has excellent heat resistance and adhesive properties, a bonding sheet using the composition, and adhesive laminated film for covering an accelerator beam tube and for covering a conductor wire for an accelerator quench heater, which have excellent workability, flexibility, and radiation resistance at a low temperature and especially have excellent adhesive properties. The polyimide is obtained by reacting an acid dianhydride represented by the general formula (1)

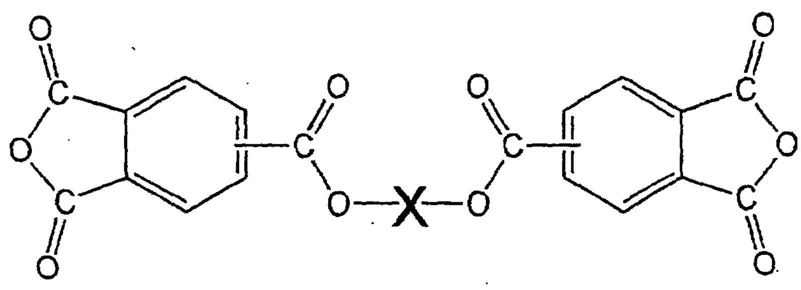

(1)

(wherein X represents a bivalent organic group having $-(CH_2)_k-$ or an aromatic group and k is an integer of 1 to 10) with a compound represented by the general formula (2)

EP 1 281 727 A1

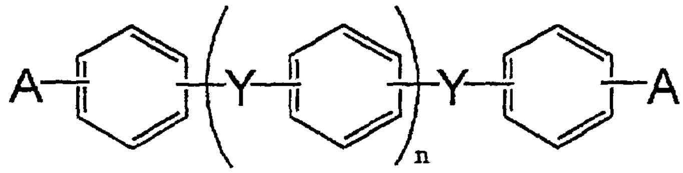 (2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10). The polyimide has a solubility of 10% or higher at 20°C even in a low-boiling organic solvent, and has a glass transition temperature of 100°C to 250°C and water absorption of 1.5% or lower. Specially, by mixing with epoxy resin, the soluble polyimide is used as a composition, solution of polyimide adhesive, laminator, bonding sheet, and adhesive laminated films suitable for covering an accelerator beam tube or for covering a conductor wire for an accelerator quench heater.

## Description

BACKGROUND OF THE INVENTION

Field of the Invention

The present invention relates to a soluble polyimide having an excellent heat resistance and low water absorption, a composition containing the soluble polyimide, which is cured at a relatively low temperature and has excellent heat resistance and adhesive properties, a bonding sheet using the composition, and adhesive laminated films for covering an accelerator beam tube and for covering a conductor wire for an accelerator quench heater, which have excellent workability, flexibility, and radiation resistance at a low temperature and especially have excellent adhesive properties.

Description of Related Art

Recently, electronic apparatuses have been rapidly growing more multifunctional, more sophisticated, and smaller, and there has been a growing demand for more compact and more lightweight electronic parts to be used in the electronic apparatuses. Also, there has been a growing demand for higher-density and more multifunctional and sophisticated semiconductor device packages and wiring materials and parts for mounting the packages. Particularly, there has been an increasing demand for a material having excellent adhesive properties which can be suitably used as a high-density packaging material such as a semiconductor package, chip-on-lead (COL) package, lead-on-chip (LOC) package, and multi chip module (MCM); a material for a printed wiring board such as multilayer flexible printed circuit board (FPC), a material used in an aerospace field, and a fixing material for automotive parts.

For example, for a bonding sheet which is used as a bonding material for a semiconductor package and other packaging materials, excellent adhesive properties, heat resistance, flexibility, and workability have been intensively demanded.

In view of excellent mechanical properties, heat resistance, and insulating characteristics, NBR/phenol resin, epoxy phenol resin/NBR, NBR/epoxy resin, epoxy resin/polyester resin, epoxy resin/acryl resin, acryl resin, or the like has been used as an adhesive agent for a bonding sheet. As the demand for higher-density printed wiring board and multi-layered flexible printed circuit board increase, it has been increasingly desired to boost a performance of a bonding sheet for bonding layers. However, conventional bonding sheets have some problems in adhesive strength, heat resistance, flexibility, workability, and the like.

For example, an adhesive agent derived from NBR is quite susceptible to heat. Adhesive agents derived from phenol and epoxy are superior in adhesive strength but inferior in flexibility. A polyester adhesive agent has excellent flexibility but has low heat resistance. An acrylic adhesive agent has excellent flexibility but low heat resistance. Since the acrylic adhesive must be heated for press-bonding at a high temperature for a long time, it is poor in workability. Thus, no conventional adhesive agents have satisfactory quality.

In these fields, a polyimide adhesive has been increasingly used, because it has sufficient flexibility which phenolic and epoxy adhesives do not have and heat resistance which an acrylic adhesive does not have.

Polyimide has been widely used because it is more excellent heat resistance than any other organic polymers. It is used even in an aerospace field and is used as a heat-resistant adhesive agent.

However, the heat-resistant polyimide adhesive must be bonded at a high temperature in the neighboring of 300°C and at high pressure but does not have very high adhesive strength. Further, it has very low solubility in an organic solvent, and is only soluble in limited solvents such as DMF and DMAc. Since these high-boiling solvents cannot be completely removed from a film after an adhesive solution is applied to the film and then dried, it has been found out that the residual solvents left in the film causes bubbles in the film. Further, since a conventional polyimide adhesive has high water absorption, lead frames having a polyimide adhesive tend to blister when it is dipped in a solder bath.

An aromatic polyimide which is widely used as an electric and electronic material because of its excellent heat resistance, mechanical properties, electric properties, and the like is generally insoluble and infusible. Therefore, where an aromatic polyimide which is used as a heat-resistant adhesive agent by being applied to an adherend in a liquid state, a polyamic acid solution, that is, a precursor of aromatic polyimide, is applied to the adherend and then heated to complete an imidization reaction. However, this imidization reaction must be carried out at a high temperature in the neighboring of 300°C, and product defects are caused by by-product water generated in the imidization reaction. When the polyamic acid solution is mixed with another resin such as thermosetting resin, some thermosetting resin are reacted with an amid group of polyamic acid. For this reason, there is limit to selection of the resin to be mixed.

Accordingly, various soluble polyimides have been proposed so far. Japanese Unexamined Patent Publications (Patent Kokai) No. 11-071457 and No. 11-222523 disclose soluble polyimides of a siloxane structure. However,

these polyimides has low heat resistance if the siloxane content is high, whereas they have high water absorption and are hard to be dissolved if the siloxane content is low. Thus, it has been difficult to obtain polyimide having high heat resistance together with an excellent solubility and low water absorption.

As the elementary particle physics moves forward, a higher-energy accelerator has been increasingly produced. In order to generate high energy, the accelerator must have a magnet capable of passing large currents and generating a strong magnetic field. Recently, a superconducting magnet has been used as a wire material for the magnet in many cases. This wire material is made of conductive metal such as copper in which a bunch of superconducting thin wires are contained. As the superconducting wire material, Nb-Ti, $NbSn_3$, $VGa_3$ or the like is used. Nb-Ti is used in many cases. When a thermosetting adhesive agent is used for insulating coating, the application of heat having a certain temperature or more causes the degradation of the superconducting wire material by heat, and thereby the properties of the magnet are deteriorated. Therefore, it has been desired to develop an adhesive agent with high adhesion, which can be cured at lower temperature than the thermal-degradation of a superconducting wire material.

An accelerator is a device which accelerates and collides particles such as protons and electrons to determine elementary particles generated by the collision and in which a large amount of radiation is generated by collision. Therefore, an insulating coating material and adhesive agent for a superconducting magnet must have an excellent radiation resistance.

Prepreg of thermosetting resin which is composed mainly of epoxy resin has been used for coating such superconducting magnet, particularly a superconducting accelerator beam tube to be used at a very low temperature. However, since epoxy resin does not have sufficient radiation resistance, the use of thermoplastic resin having radiation resistance has been studied.

In the case of an accelerator in which a superconducting magnet is used, there has been a fear of corruption of the accelerator by resistance developed when the balance of superconducting state comes undone for some reasons. Therefore, the accelerator comprises a quench heater as a safety device. In the quench heater, an accelerator ring with a plate-like electric heating element can entirely release the superconductive state when abnormal condition occurs. Since a large amount of radiation is generated by collision, an insulating coating material and adhesive agent for a superconducting magnet must have an excellent radiation resistance.

Since polyimide has excellent heat resistance, low-temperature properties, chemical resistance, and electrical characteristics, it has been widely used particularly as materials for electric or electronic apparatuses. Conventional polyimide films are insoluble and infusible. Therefore, a polyimide film which is laminated with thermoplastic resin such as fluororesin has took the form of a composite material for coating a conductor wire for superconducting accelerator quench heater which is used at a cryogenic temperature.

However, the fluororesin does not have sufficient radiation resistance. Since it is expected to increase the amount of radiation generated in the accelerator in the future with an increase in energy produced by the accelerator, radiation resistance is increasingly desired. For this reason, a thermoplastic polyimide resin has been studied for use as a heat-sealing layer having an excellent heat resistance.

## DISCLOSURE OF THE INVENTION

The present invention solves the above problems and provides a soluble polyimide having an excellent solubility, high heat resistance, and low water absorption, a composition containing the polyimide, a bonding sheet, and adhesive laminated films for covering an accelerator beam tube and for covering a conductor wire for an accelerator quench heater.

Specifically, the soluble polyimide of the present invention has a solubility of 10 % or higher at 20°C in an organic solvent of N, N-dimethylformamide, 1,4-dioxane, 1,3-dioxolane, or tetrahydrofuran.

Further, the soluble polyimide of the present invention has a solubility of 10 % or higher at 20°C in an organic solvent of N, N-dimethylformamide, 1,4-dioxane, 1,3-dioxolane, or tetrahydrofuran, and has a glass transition temperature of 100°C to 250°C and has water absorption of 1.5 % or lower.

Furthermore, the soluble polyimide of the present invention can be obtained by reacting ester acid dianhydride represented by the general formula (1)

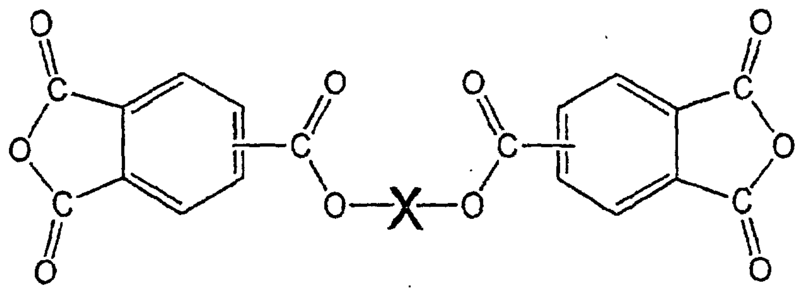 (1)

(wherein X represents a bivalent organic group including $-(CH_2)_k-$ or an aromatic group and k is an integer of 1 to 10) with a diamine or diisocyanate compound represented by the general formula (2)

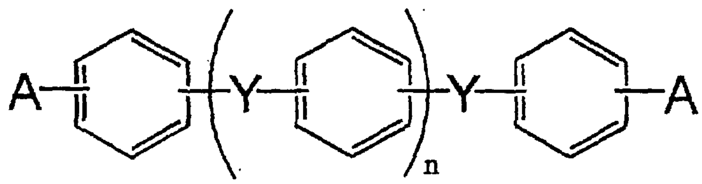 (2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O-, or a single bond, and m and n each are an integer of 0 to 10).

The acid dianhydride represented by the general formula (1) may be 2,2-bis(4-hydroxyphenyl)propane dibenzoate-3,3',4,4'- tetracarboxylic dianhydride represented by

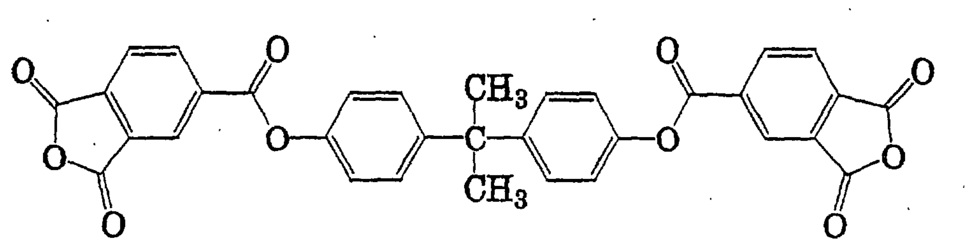

Further, the soluble polyimide of the present invention may be obtained by reacting the diamine or diisocyanate component represented by the general formula (2) with an acid dianhydride component including 50 mol% or more of 2,2-bis(4-hydroxyphenyl)propane dibenzoate-3,3',4,4'- tetracarboxylic dianhydride represented by the following structural formula:

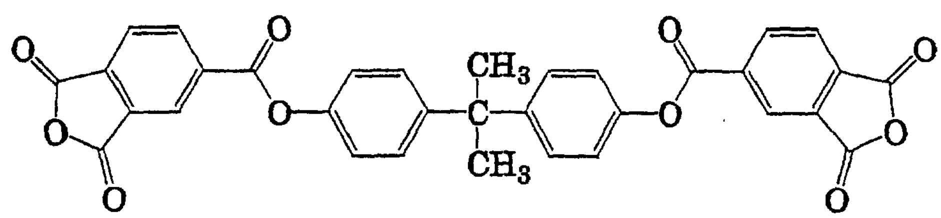

The general formula (2) can be represented by

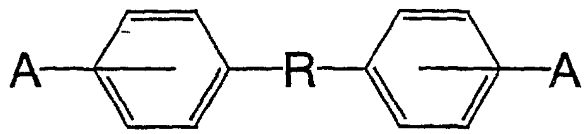

(wherein A represents $-NH_2$ or -NCO and R is a bivalent organic group selected from the group consisting of $-CH_2-$ and

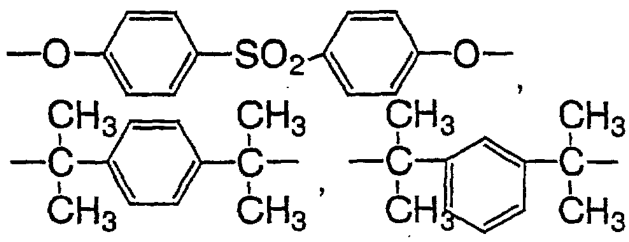

).

The diamine or diisocyanate compound represented by the above general formula may be 1,3-bis(aminophenoxy)benzene;

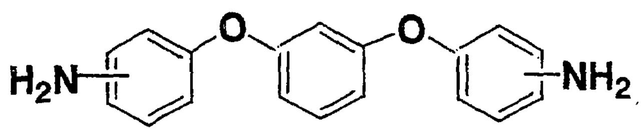

or 1,3-bis(isocyanatephenoxy)benzene;

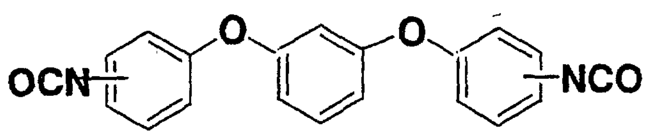

Further, the diamine or diisocyanate compound represented by the general formula (2) may be represented by the following general formula (4)

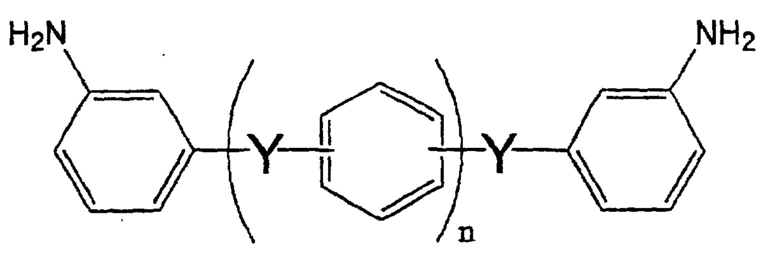

(4)

(wherein Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10).

Further, the soluble polyimide of the present invention may be obtained by heating an organic solvent solution of polyamide acid obtained by reacting an acid dianhydride component including ester acid dianhydride represented by the general formula (1)

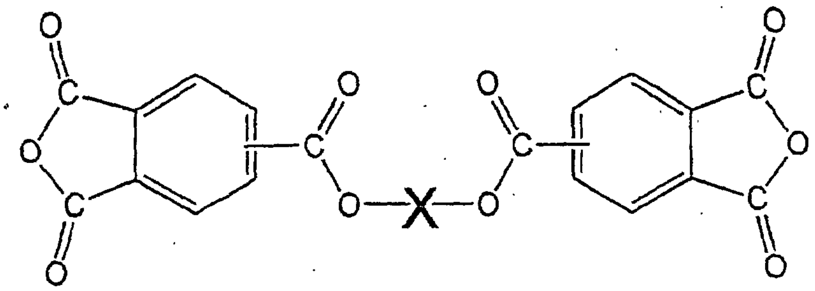

(1)

(wherein X represents a bivalent organic group including $-(CH_2)_k-$ or an aromatic group and k is an integer of 1 to 10) with a diamine component including diamine represented by the general formula (2)

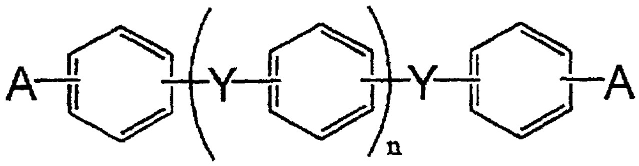

(2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10) in an organic solvent under a reduced pressure to imidize the polyamide acid.

The organic solvent solution of polyamide acid may be heated at a temperature of 80°C or higher to 400°C or lower and/or under a pressure of $0.001\times10^5$ to $0.9\times10^5$ Pa.

A composition of the present invention is a resinous composition for an adhesive agent which contains polyimide resin and epoxy resin, and the polyimide resin of the composition is obtained by reacting an acid dianhydride component including ester acid dianhydride represented by the general formula (1)

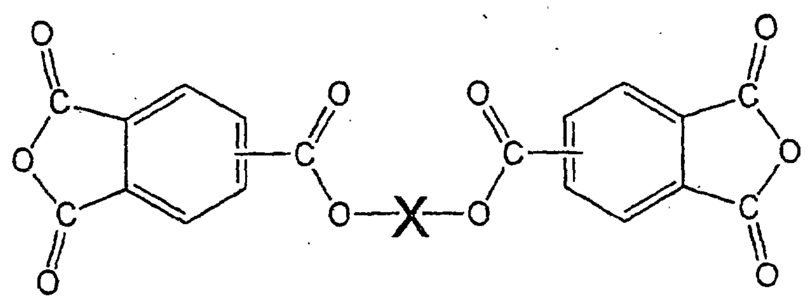

(1)

(wherein X represents a bivalent organic group including $-(CH_2)_k-$ or an aromatic group and k is an integer of 1 to 10) with a diamine component including diamine represented by the general formula (2)

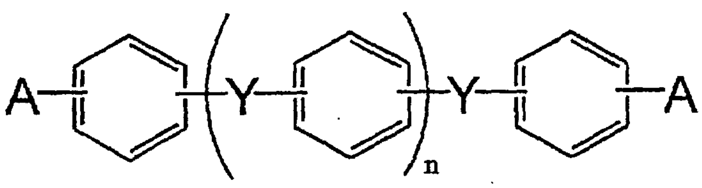

(2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10).

The composition of the present invention is a resinous composition for an adhesive agent which contains

polyimide resin and epoxy resin, and the polyimide resin of the composition is obtained by reacting ester acid dianhydride represented by the general formula (1)

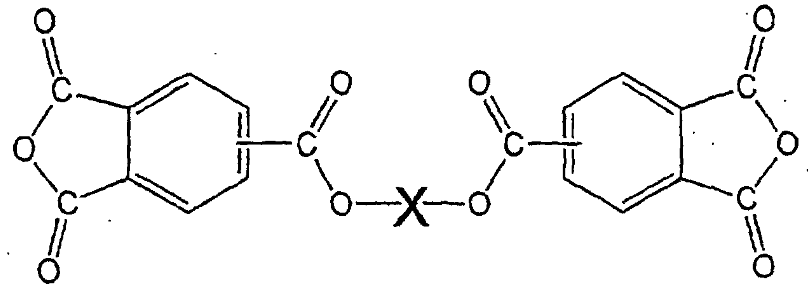

(1)

(wherein X represents a bivalent organic group including $-(CH_2)_k-$ or an aromatic group and k is an integer of 1 to 10) with a diamine component. In the diamine component, diamine represented by the general formula (2)

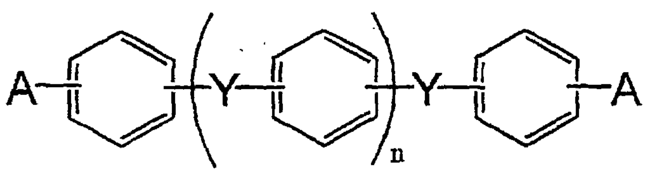

(2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10) makes up 0 to 99 mol% of the whole diamine component and 3,3'-dihydroxy-4,4'-diaminobiphenyl represented by the general formula (3)

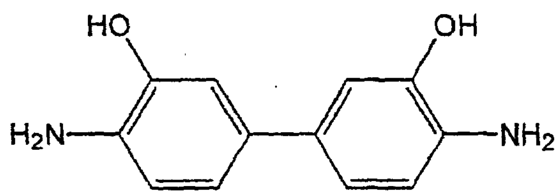

(3)

makes up 1 to 100 mol% of the whole diamine component.

Further, the composition of the present invention may contain at least one kind of solvent having a low boiling point.

Furthermore, thermoplastic polyimide, epoxy resin, and curing agent contained in the composition may be soluble in an organic solvent. The organic solvent may contain cyclic ether solvent.

The organic solvent can contain 30 wt% or more of cyclic ether solvent.

A bonding sheet of the present invention comprises at least an adhesive layer. The adhesive layer is made of a resinous composition containing polyimide resin and epoxy resin. The polyimide resin used herein is a soluble polyimide having a solubility of 10 % or higher at 20°C in an organic solvent of N, N-dimethylformamide, 1,4-dioxane, 1,3-dioxolane, or tetrahydrofuran.

In the bonding sheet of the present invention, the soluble polyimide resin can be obtained by reacting ester acid dianhydride represented by the general formula (1)

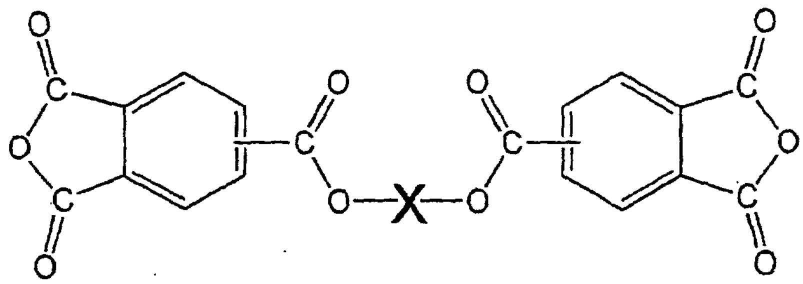

(1)

(wherein X represents a bivalent organic group having $-(CH_2)_k-$ or an aromatic group and k is an integer of 1 to 10) with a diamine or diisocyanate component represented by the general formula (2)

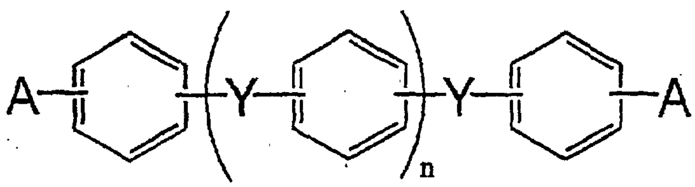

(2)

(wherein A represents $-NH_2-$ or -NCO, Y independently represents -C(=O)-, $-SO_2-$, -O-, -S-, $-(CH_2)_m-$, -NHCO-, $-C(CH_2)_m-$, $-C(CF_3)_2-$, -C(=O)O- or a single bond, and m and n each are an integer of 0 to 10).

Further, the soluble polyimide resin may be obtained by reacting an acid dianhydride component including 2,2-bis(4-hydroxyphenyl)propane dibenzoate-3,3',4,4'- tetracarboxylic dianhydride represented by the following formula (2)

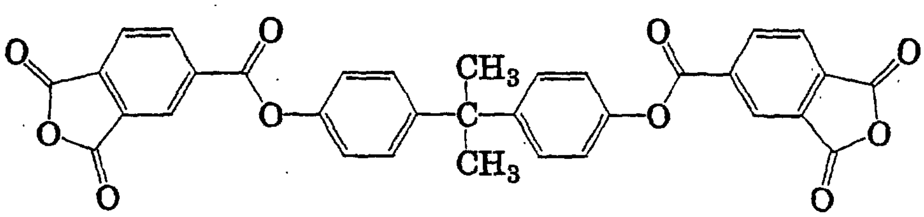

with a diamine or diisocyanate component.

The soluble polyimide resin may be obtained by reacting an acid dianhydride component with a diamine component or diisocyanate component containing 1,3-bis(aminophenoxy)benzene;

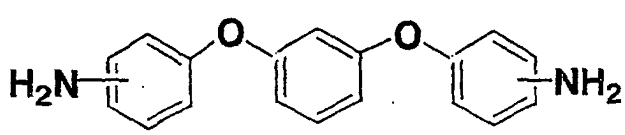

or 1,3-bis(isocyanatephenoxy) benzene;

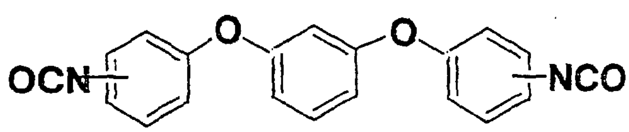

Further, if the adhesive layer is cured, a residual volatile left in the cured layer may be 3 wt% or less of the total weight of the cured layer and/or the cured layer may have water absorption of 1.5 % or less.

The bonding sheet of the present invention can be obtained by casting or applying any one of the above

compositions over a base and then drying and peeling it form the base.

Another bonding sheet of the present invention may have a polyimide adhesive layer on at least one surface thereof, which can be obtained by casting any one of the above compositions over at least one surface of a polyimide film and then drying it.

The polyimide adhesive layer may have a thickness of 5 to 30 μm.

Further, the bonding sheet of the present invention comprises at least an adhesive layer, and main components of the composition contained in the adhesive layer are as follows:

| | |
|---|---|
| I) soluble polyimide resin | 100 parts by weight |
| II) epoxy resin | 3 to 100 parts by weight |
| III) accelerator or curing agent | 0.5 to 50 parts by weight |

Further, still another bonding sheet of the present invention can have a release film on at least one side thereof.

The release film used herein can be made of PET (polyethylene terephthalate) or PEN (polyethylene naphthalate).

An adhesive laminated film for covering an accelerator beam tube is a laminated film having an adhesive layer on at least one surface of a polyimide film. The adhesive layer is made of a composition containing a thermoplastic resin having a glass transition temperature of 100°C to 250°C and an water absorption of 1.5 % or less and a thermosetting resin.

The thermoplastic resin used herein may be a soluble polyimide resin which can be obtained by reacting an acid dianhydride component containing ester acid dianhydride represented by the general formula (1)

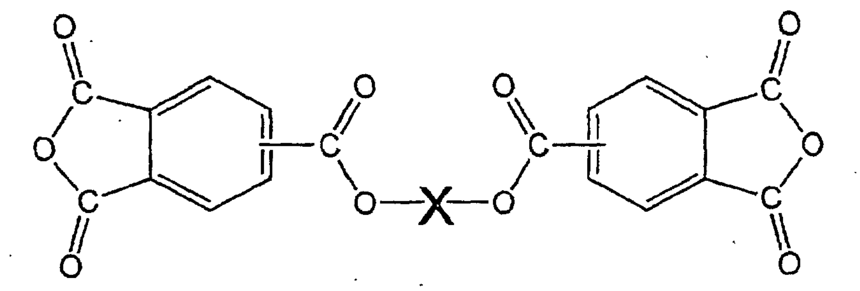
(1)

(wherein X represents a bivalent organic group including $-(CH_2)_k-$ or an aromatic group and k is an integer of 1 to 10) with a diamine compound represented by the general formula (2)

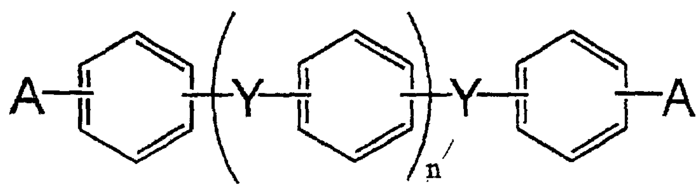
(2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10).

The thermosetting resin can be a resin having more than one epoxy group in each molecule.

An adhesive laminated film for covering a conductor wire for an accelerator quench heater is a laminated film having an adhesive layer on at least one surface of a polyimide film The adhesive layer is made of a composition containing a thermoplastic resin having a glass transition temperature of 100°C to 250°C and water absorption of 1.5 % or less and a thermosetting resin.

The thermoplastic resin used herein may be a soluble polyimide resin which can be obtained by reacting an acid dianhydride component including ester acid dianhydride represented by the general formula (1)

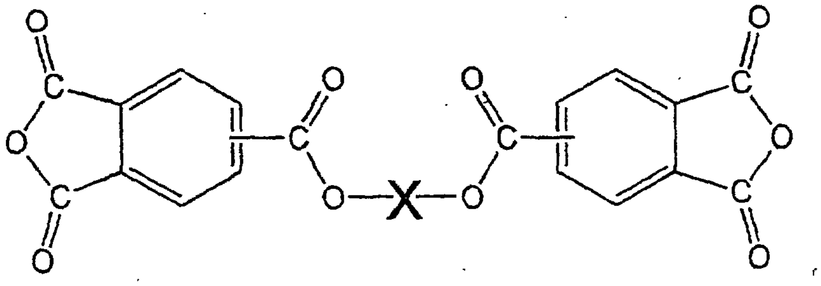

(1)

(wherein X represents a bivalent organic group including $-(CH_2)_k-$ or an aromatic group and k is an integer of 1 to 10) with a diamine compound represented by the general formula (2)

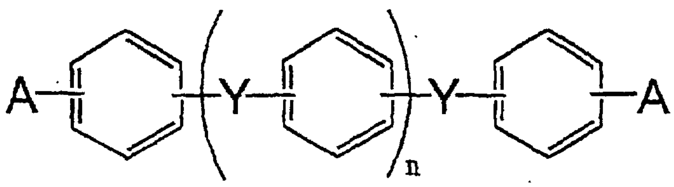

(2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10).

The thermosetting resin may be a resin having more than one epoxy group in each molecule.

BRIEF DESCRIPTION OF THE DRAWING

FIG. 1 is a sectional view of an adhesive laminated film for covering an accelerator beam tube or for covering a conductor wire for an accelerator quench heater.

FIG. 2 is a perspective view for illustrating a method of covering an accelerator beam tube or a conductor wire for an accelerator quench heater with an adhesive laminated film according to the present invention.

FIG. 3 is a perspective view for illustrating another method of covering an accelerator beam tube or a conductor wire for an accelerator quench heater with an adhesive laminated film according to the present invention.

FIG. 4 is sectional view of a conductor wire for an accelerator quench heater which is covered with an adhesive laminated film for covering an accelerator beam tube or for covering a conductor wire for an accelerator quench heater according to the present invention.

DESCRIPTION OF THE PREFERRED EMBODIMENTS

A soluble polyimide according to the present invention has a solubility of 10 % or higher at 20°C in an organic solvent of N, N-dimethylformamide, 1,4-dioxane, 1,3-dioxolane, or tetrahydrofuran. The soluble polyimide also has a glass transition temperature of 100°C to 250°C and water absorption of 1.5 % or less. A preferable thermoplastic resin having such properties is obtained by reacting acid dianhydride including ester acid dianhydride represented by the general formula (1)

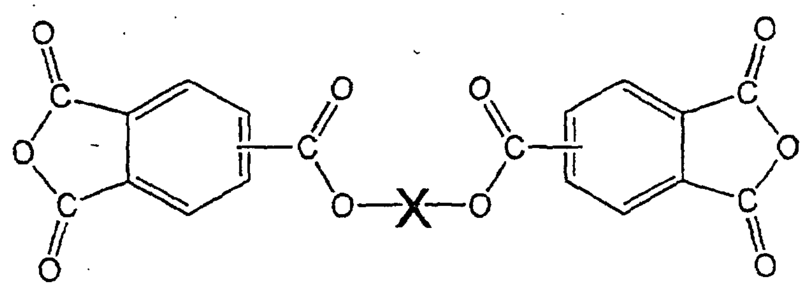 (1)

(wherein X represents a bivalent organic group including $-(CH_2)_k-$ or an aromatic group and k is an integer of 1 to 10) with a diamine or diisocyanate compound represented by the general formula (2)

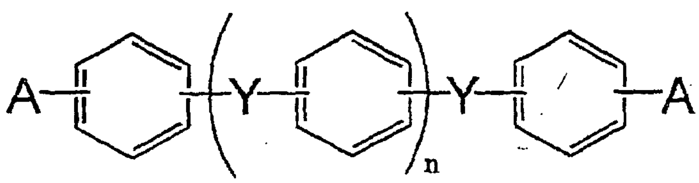 (2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10) in an organic solvent under a reduced pressure.

Since a polyimide resin having low water absorption can be obtained by the use of ester acid dianhydride represented by the general formula (1), it is preferable that the acid dianhydride contains the ester acid dianhydride represented by the general formula (1). More preferably, the ester acid dianhydride constitutes 50 % or more mol% of the total acid dianhydride component.

Examples of the preferable ester acid dianhydride represented by the general formula (1) include: 2,2-bis (4-hydroxyphenyl)propane dibenzoate-3,3',4,4'- tetracarboxylic dianhydride, p- phenylenebis (trimellitic monoester anhydride), 4,4'-biphenylenebis (trimellitic monoester anhydride), 1,4-naphthalenebis (trimellitic monoester anhydride), 1,2-ethylenebis (trimellitic monoester anhydride), 1,3-trimethylenebis (trimellitic monoester anhydride), 1,4-tetramethylenebis (trimellitic monoester anhydride), 1,5-pentamethylenebis (trimellitic monoester anhydride), and 1,6-hexamethylene bis (trimellitic monoester anhydride. One or more kinds of the ester acid dianhydrides can be used as acid dianhydride or a portion of acid dianhydride.

2,2-bis(4-hydroxyphenyl)propane dibenzoate-3,3',4,4'-tetracarboxylic dianhydride (hereinafter referred to as "ESDA") represented by the following structural formula:

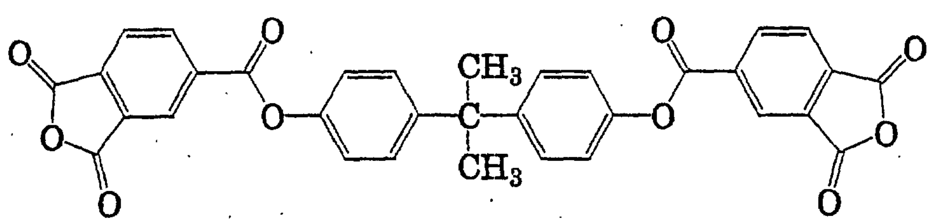

is particularly preferable to obtain a thermoplastic polyimide resin having a solubility in a solvent, excellent workability, and high heat resistance in good balance. Since a degree of solubility increases with content of ESDA. The ESDA content is preferably 50 mol% or more, more preferably 70 mol% or more, and most preferably 90 mol% or more of the total acid dianhydride.

Examples of the preferable diamine or diisocyanate component is represented by the following general formula (2)

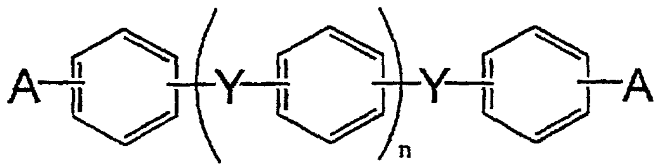

(2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10). The above compounds can be used alone or in combination. In the general formula (2), Y's may be the same or different in each repeating unit. A hydrocarbon group such as methyl group and ethyl group or halogen group such as Br and Cl may be introduced to each benzene ring.

The diamine or diisocyanate compound represented by the general formula (2) preferably constitutes 50 % or more of the total amount of diamine or diisocyanate, more preferably 70 % or more, and most preferably 90 % or more.

Further, a preferable diamine compound is represented by the general formula (3)

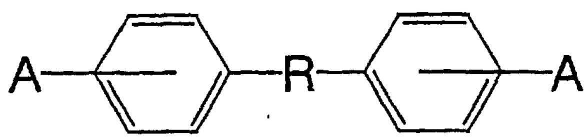

(wherein A represents $-NH_2$ or -NCO and R is a bivalent organic group selected from the group consisting of $-CH_2-$,

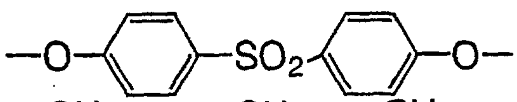

,

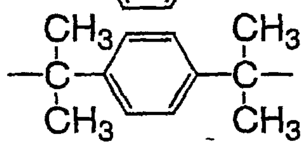

,

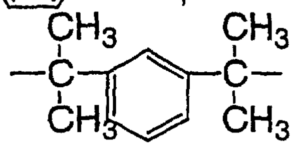

).

A polar group such as $-SO_2$ and a single bond and an isopropyl group have the effect of increasing a solubility. Since the diamine represented by the general formula (3) contains such organic groups, it is preferably used in terms of solubility.

Also, in the general formula (2), it is preferable to use a diamine or diisocyanate component including 1,3-bis(aminophenoxy)benzene represented by the following structural formula

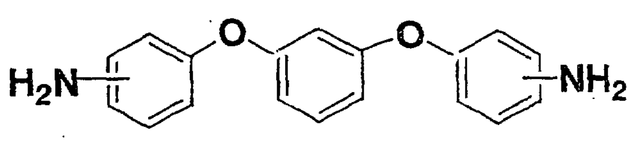

or 1,3-bis(isocyanatephenoxy)benzene represented by the following general formula

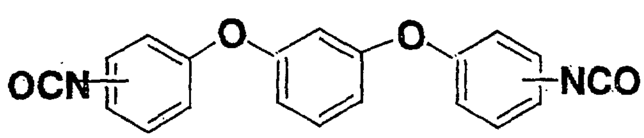

1,3-bis(aminophenoxy)benzene or 1,3-bis(isocyanatephenoxy)benzene is preferably used because each provides excellent solubility to the polyimide.

Among the compounds represented by the general formula (1), a compound having an amino group or an isocyanate group at a meta position, which is represented by the general formula (4)

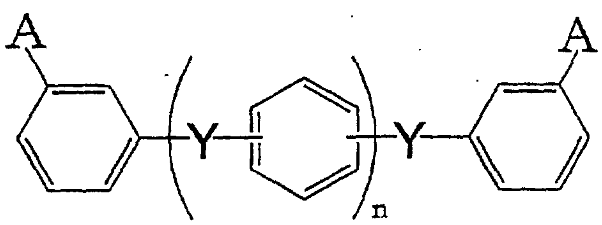

(4)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10), is preferably used because it provides more excellent solubility to a thermoplastic polyimide resin than a diamine compound having an amino group at a para position or a isocyanate compound having an isocyanate group at a para position does.

For example, bis(aminophenoxy phenyl)sulfone is preferably used. Particularly, meta-type bis(aminophenoxy phenyl) sulfone represented by the following structural formula

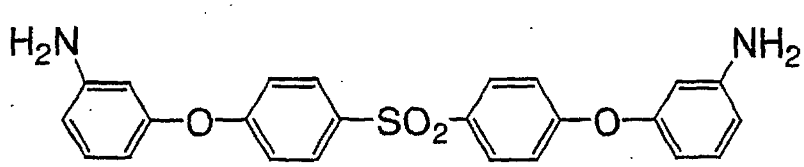

is preferably used because it provides high solubility to the thermoplastic polyimide resin.

Among the compounds represented by the general formula (4), the 1,3-bis(aminophenoxy)benzene or 1,3-bis (isocyanatephenoxy)benzene having an amino group at a meta position is more preferably used than the one having an amino group at a para position, because it provides more excellent solubility to the polyimide.

As stated above, the diamine represented by the general formula (2) or (4) has an effect of increasing a solubility of the polyimide resin. More preferably, such diamine constitutes 50 to 99 mol% of the total diamine components, and most preferably 80 to 99 mol%.

Next, a method of producing the soluble polyimide according to the present invention will be described. First, a method of producing a soluble polyimide by reacting acid dianhydride represented by the general formula (1) with diamine represented by the general formula (2) will be described as an example. The soluble polyimide of the present invention can be produced by a synthesizing procedure which is applicable to a method of producing a typical polyimide. Following is a general synthesizing procedure.

A polyamide acid polymer precursor is produced by reacting acid dianhydride with a diamine compound in an organic solvent, and then dehydrated to effect ring closure. In this case, the acid dianhydride component and diamine component are equimolar or substantially equimolar. Preferable molar ratio is:

acid dianhydride component : diamine component = 0.98:1 to 1.02:1

The respective components are added at random.

The reaction of acid dianhydride with diamine is made by dissolving or diffusing one or more kinds of the diamine compound represented by the general formula (2) in an organic polar solvent and then adding one or more kinds of ester acid dianhydride represented by the general formula (1) to the solvent, for example. The order of adding each monomer is not particularly limited. The acid dianhydride may be added first to the organic polar solvent and then the diamine compound is added to produce a solution of polyamide acid polymer. Alternatively, a certain amount of the diamine compound, acid dianhydride, and the rest of diamine compound may be added in this order in the organic polar solvent to produce a polyamide acid polymer solution, In addition, there are various other monomer adding methods which are known to the persons skilled in the art.

The reaction temperature is 80°C or lower, preferably 0°C to 50°C. The reaction time is arbitrarily set within

a range of 30 minutes to 50 hours. As the reaction proceeds, more amount of polyamide acid is produced, and thereby the viscosity of the reaction solution is increased.

A polyimide can be prepared by dehydration ring-closure of a polyamide acid solution. There are two methods for dehydration ring-closure. The one is thermal dehydration ring-closure in which the polyamide acid solution is heated and then dehydrated, and the other is chemical dehydration ring-closure in which the polyamide acid solution is dehydrated using a dehydrating agent.

In the thermal dehydration ring-closure, polyamide acid is heated at 150°C or more for imidization. Specifically, a polyamide acid solution may be cast over or applied to a film base such as a glass plate, metal plate, and PET and then heated at 80°C to 300°C. Alternatively, a polyamide acid solution is directly put into a container coated with mold release agent such as Teflon and then heated and dried in a vacuum to obtain a polyimide. In general, the heating time is preferably one minute to five hours after heating temperature reaches its peak, although it depends on the thickness of the polyamide and maximum heating temperature.

Among thermal imidization methods, a preferable thermal imidization method is a method in which polyamide acid solution is heated under a reduced pressure. By such imidization method, water generated in imidization can be actively removed out of the reaction system and the hydrolytic degradation of polyamide acid can be prevented. Therefore, polyimide of high-molecular weight can be obtained. Also, particularly preferable molecular-weight polyimide can be expected to be obtained because the rings of the impurities close again.

In a thermal imidization under a reduced pressure, a preferable heating temperature is 80°C to 400°C. More preferable heating temperature is 100°C or more, because imidization and water removal are carried out efficiently at 100°C or more. Most preferable heating temperature is 120°C or more. Maximum heating temperature is preferably lower than thermal decomposition temperature of a desired polyimide. In general, an imidization completion temperature, namely, about 250°C to 350°C, is adopted.

A reduced pressure is preferably low. Specifically, a preferable reduced pressure is 0.001 X $10^5$ to 0.9 X $10^5$ Pa, more preferably 0.001 X $10^5$ to 0.8 X $10^5$ Pa, and most preferably 0.01 X $10^5$ to 0.7 X $10^5$ Pa.

In the chemical imidization method, not less than a stoichiometric amount of dehydrating agent and a catalytic amount of tertiary amine are added to the polyamide acid solution and then the same process as done in the thermal imidization method is conducted, and thus a desired polyimide can be obtained. Examples of the dehydrating agent used herein include: aliphatic acid anhydrides such as acetic anhydride; and aromatic acid anhydrides. Examples of the catalyst include: aliphatic tertiary amines such as triethylamine; aromatic tertiary amines such as dimethylaniline; heterocyclic tertiary amines such as pyridine, isoquinoline, α-picoline, β-picoline, and γ-picoline.

In another method of producing the soluble polyimide according to the present invention, an acid dianhydride component including acid dianhydride represented by the general formula (1), particularly ESDA, is reacted with a diisocyanate component including diisocyanate represented by the general formula (2) wherein A represents -NCO, in an organic solvent or in the absence of an organic solvent to obtain polyimide without using polyamide acid.

The polyimide synthesized by the use of acid dianhydride represented by the general formula (1) and diisocyanate represented by the general formula (5)

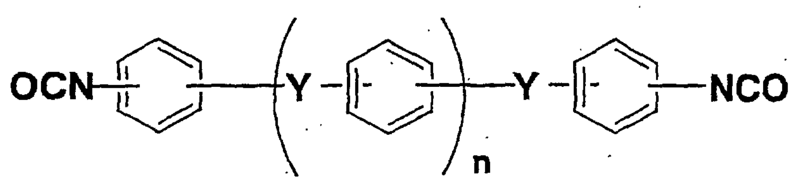

(5)

(wherein Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10) has an excellent solubility in an organic solvent. Therefore, a diisocyanate component to be reacted preferably contains 50 mol% of or more of the diisocyanate represented by the general formula (5), more preferably 70 mol%, and particularly preferably 90 mol%. In the general formula (5), Y's may be the same or different in each repeating unit. A hydrocarbon group such as a methyl group and ethyl group or a halogen group such as Br and Cl may be introduced to each benzene ring.

Among the diisocyanates represented by the general formula (5), a polyimide resin produced using 1,3-bis (isocyanatephenoxy)benzene has more excellent solubility. The amount of 1,3-bis(isocyanatephenoxy)benzene is preferably 50 mol% or more of the total diamine components to be reacted, more preferably 70 mol% or more, and most preferably 90 mol% more.

1,3-bis(3-isocyanatephenoxy)benzene having an isocyanate group at a meta position, which is represented by the following structural formula

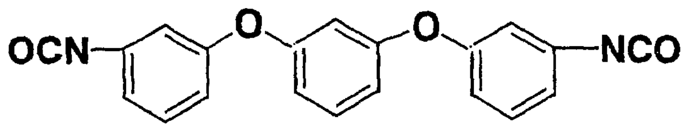

, is particularly preferably used because it provides more excellent solubility to a polyimide than 1,3-bis(4-isocyanatephenoxy)benzene having an isocyanate group at a para position.

The soluble polyimide obtained by reacting diamine and acid dianhydride is, in many cases, obtained as a solution of an organic solvent used in the polymerization of polyamide acid. The soluble polyimide obtained by reacting diisocyanate and acid dianhydride is also obtained as a solution of an organic solvent used at the start of the reaction. These organic solvents may not be always removed, but may be used in a subsequent step as it is. The polyimide in the above state may be purified to obtain solid-state polyimide such as polyimide powders.

An example of a method of purifying the soluble polyimide is as follows. The soluble polyimide resin solution is put into a poor solvent which is compatible with a solvent used in the polymerization of polyamide acid but which does not dissolve the soluble polyimide, the soluble polyimide is precipitated, unreacted monomer is removed from the polyimide, and then the polyimide is dried to obtain the solid purified soluble polyimide. Examples of the poor solvent include acetone, methanol, ethanol, isopropanol, benzene, metylcellosolve, and methyl ethyl ketone. The solid polyimide can be stored, and can be dissolved in a solvent when it is used.

The polyimide obtained by reacting the acid dianhydride represented by the general formula (1) with the diamine component or diisocyanate component represented by the general formula (2) is a soluble polyimide which has a solubility of 10 % or higher at 20°C in an organic solvent of N, N-dimethylformamide, 1,4-dioxane, 1,3-dioxolane, or tetrahydrofuran. When this soluble polyimide is used as an adhesive agent in a field of electronic material, a water absorption of polyimide is preferably 2.0 % or lower, more preferably 1.5 % or lower, and most preferably 1.0 % or lower. This is because a substrate material for an electronic circuit having excellent dielectric properties can be easily obtained from such polyimide having a low solubility.

The polyimide preferably has a glass transition temperature of 100° C to 250°C, preferably 120°C or higher, more preferably 150°C or higher, and most preferably 180°C or higher. If the polyimide is used as a substrate material which is to be heated in a solder reflow reactor at a temperature in the neighboring of 240°C, it is important that polyimide has a glass transition temperature of 160°C or higher. The soluble polyimide having a suitable glass transition point according to the present invention can be selected from the polyimides obtained by reacting the diamine with the acid anhydride.

When the soluble polyimide according to the present invention is used for a solvent-type adhesive agent, the adhesive agent can have a solubility of 10 % or higher at 20°C in an organic solvent of N, N-dimethylformamide, 1,4-dioxane, 1,3-dioxolane, or tetrahydrofuran. Furthermore, the agent can also have a solubility of 15 % or higher or 20 % or higher.

Next, a composition of the present invention will be described. The composition of the present invention comprises: a polyimide obtained by reacting any one of the above acid dianhydrides with any one of the above diamine or diisocyanate components; and thermosetting rein, especially an epoxy resin.

The diamine to be used to produce the soluble polyimide contained in the composition according to the present invention is represented by the general formula (2)

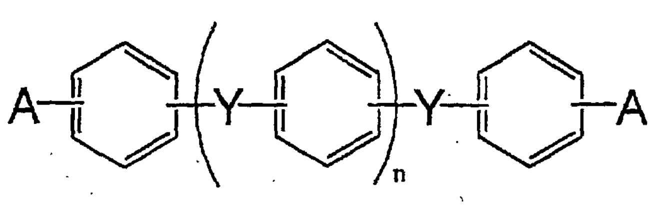 (2)

(wherein A represents $-NH_2$- or -NCO, Y independently represents -C(=O)-, $-SO_2$-, -O-, -S-, $-(CH_2)_m$-, -NHCO-, $-C(CH_3)_2$-, $-C(CF_3)_2$-, -C(=O)O- or a single bond, and m and n each are an integer of 0 to 10) and one or a combination of the diamines can constitutes 0 to 99 mol% of the total diamine component. In the general formula (2), Y's may be the same or different in each repeating unit. A hydrocarbon group such as methyl group and ethyl group or halogen group such as Br and Cl may be introduced to each benzene ring.

The diamine or diisocyanate compound represented by the general formula (2) and having an amino group or isocyanate group at a meta position, namely, the diamine compound or the diisocyanate compound represented by

the following general formula (4)

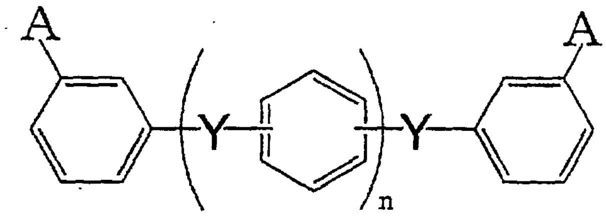

(4)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10) is preferably used because it provides more excellent solubility to a thermoplastic polyimide resin than a compound having an amino group at a para position.

Preferably, the composition of the present invention is combined with a diamine compound represented by

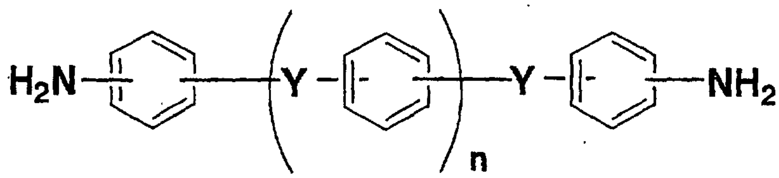

(6)

(wherein Y independently represents -C(=O)-, $-SO_2-$, -O-, -S-, $-(CH_2)_m-$, -NHCO-, $-(CH_2)_m-$, $-C(CF_3)_2-$, -C(=O)O- or a single bond, and m and n each are an integer of 0 to 10), which makes up 0 to 99 mol% of the total diamine components, and 3,3'-dihydroxy-4,4'-diaminobiphenyl represented by the following structural formula

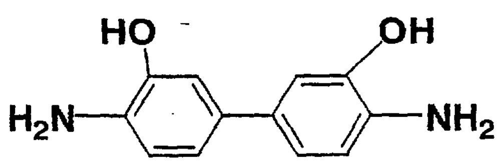

, which makes up 1 to 100 mol% of the whole diamine component.

More preferably, the diamine represented by the general formula (6) is combined with a diamine compound having an amino group at a meta position represented by the general formula (7)

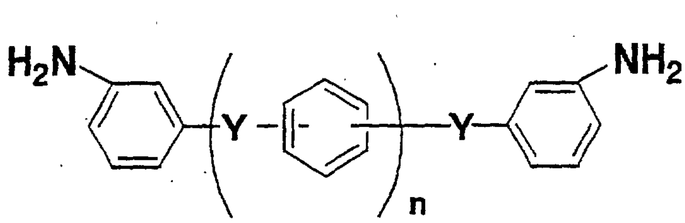

(7)

(wherein Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10), which makes up 0 to 99 mol% of the total diamine component, and 3,3'-dihydroxy-4,4'-diaminobiphenyl, which makes up 1 to 100 mol% of the whole diamine component, because it provides more excellent solubility to the polyimide than a diamine component containing a diamine compound having

an amino group at a para position.

Since a hydroxy group is introduced into the polyimide resin obtained from a combination of the diamine compound represented by the general formula (6), especially represented by the general formula (7), and 3,3'-dihydroxy-4,4'-diaminobiphenyl, such polyimide has a reactivity with an epoxy compound. Therefore, in the adhesive composition containing the polyimide resin of the present invention and an epoxy resin, a cross-linking reaction between the polyimide resin and the epoxy resin proceeds, and there can be easily provided an adhesive composition suitable for a laminate board having an excellent heat resistance, solder heat resistance, and PCT resistance. Such effects can be produced using 1 to 10 mol% of the diamine represented by the general formula (6). However, too much diamine may impair the solubility of the polyimide. Therefore, the diamine preferably makes up of 1 to 50 mol% of the polyimide resin, and more preferably 1 to 20 mol%.

Examples of the thermosetting resin contained in the composition according to the present invention include: bismaleimide, bisallylindophenol (bisallylnadiinide), epoxy resin, phenol resin, and cyanate resin. In terms of various properties, preferable thermosetting resin is epoxy rein. Any epoxy resin can be used in the present invention. Examples of epoxy resin include: bisphenol epoxy resin, hydrogenated bisphenol epoxy resin, phenol novolac epoxy rein, hydrogenerated phenol novolac epoxy resin, alkylphenol novolac epoxy resin, polyphenol epoxy resin, polyglycol epoxy resin, cyclic aliphatic epoxy resin, cresol novolac epoxy resin, glycidylamine epoxy resin, urethane modified epoxy resin, rubber modified epoxy resin, and epoxy modified polysiloxane.

For example, glycidyl ether resin such as bisphenol A-type epoxy resin and novolac resin, cyclic aliphatic epoxy resin, aromatic epoxy resin, hydrogenerated epoxy resin, and the like can be used alone or in combination. Specific examples include: bisphenol A epoxy resin (Yuka Shell Epoxy Kabushiki Kaisha: Epikote 828, 834, 1001, 1002, 1003, 1004, 1005, 1007, 1010, 1100L, etc.), brominated bisphenol A epoxy resin (Yuka Shell Epoxy Kabushiki Kaisha: Epikote 5050, 5051, 5051H etc.), o-cresol novolac resin (Yuka Shell Epoxy Kabushiki Kaisha: Epikote ESCN-220L, 220F, 220H, 220HH, 180H65, 180S65, etc.), naphthalene aralkyl novolac bisphenol A resin (Nippon Steel Chemical Co. Ltd.:ESN-185, etc.), bisphenol A novolac resin (Yuka Shell Epoxy Kabushiki Kaisha: Epikote YX4000H, etc), bisphenol A novolac resin (Yuka Shell Epoxy Kabushiki Kaisha: 157S70), trishydroxyphenyl methane novolac resin (Yuka Shell Epoxy Kabushiki Kaisha:1032H60, etc.), naphthalene aralkyl novolac resin (ESN375, etc), tetraphenylol ethane (Yuka Shell Epoxy Kabushiki Kaisha: 1031S), YGD414S (Tohto Kasei Co.,Ltd.), trishydroxyphenyl methane (NIPPON KAYAKU CO.,LTD.: EPPN502H), special bisphenol (Mitsui Chemicals, Inc.: VG3101L), special naphthol NC7000 (NIPPON KAYAKU CO.,LTD.), and glycidylamine resin TETRAD-X and TETRAD-C (MITUBISHI GAS CHEMICAL COMPANY, INC.). However, the thermosetting resin contained in the composition according to the present invention is not limited to the above resins. Among the above resins, epoxy resins having more than one epoxy groups are particularly preferable.

If the content of the polyimide resin is 100 weight parts, the content of the above thermosetting resin, especially epoxy resin, is preferably 1 to 50 weight parts, and more preferably 5 to 30 weight parts. Too less content of thermosetting resin may degrade an adhesive strength of the composition, whereas too much content of the thermosetting resin may degrade a flexibility or heat resistance of the composition.

Further, it is preferable to add an accelerator or curing agent to the composition of the present invention. Any curing agent for epoxy rein can be used. The curing agent is added to a solution of an adhesive agent so as to improve water absorption, heat resistance, and adhesive properties. Examples of a typical adhesive curing agent include: a general curing agent, accelerator, or various coupling agents for an epoxy resin derived from an acid dianhydride, amine, imidazole, or the like.

Other thermosetting resin than epoxy resin; phenol resin,; cyanate resin; and the like may be used in combination.

Examples of the accelerator include: imidazole compound such as 2-alkylimidazole, 2-alkyl-4-methylimidazole, 2-alkyl-4-ethylimidazole, 1-(2-cyanoethyl)-2-alkylimidazole (preferably having the carbon number of 1 to 4 in an alkyl group), 2-phenylimidazole, 2,4-diphenylimidazole, and 2-phenyl-4-methylimidazole; acid anhydride such as phthalic anhydride, tetrahydrophthalic anhydride, hexahydrophthalic anhydride, and trimellitic anhydride; and amines such as diethylenetriamine, triethylenetetramine, *m*-xylylenediamine, and diaminphenyl methane. They can be used alone or in combination.

The composition of the present invention is preferably composed mainly of the following ingredients.

| | |
|---|---|
| I) soluble polyimide resin | 100 parts by weight |
| II) epoxy resin | 3 to 100 parts by weight |
| III) accelerator or curing agent | 0.5 to 50 parts by weight |

The composition of the present invention is more preferably composed mainly of the following ingredients.

| | |
|---|---|
| I) soluble polyimide resin<br>II) epoxy resin<br>III) accelerator or curing agent | 100 parts by weight<br>5 to 50 parts by weight<br>1 to 20 parts by weight |

The composition of the present invention is most preferably composed mainly of the following ingredients.

| | |
|---|---|
| I) soluble polyimide resin<br>II) epoxy resin<br>III) accelerator or curing agent | 100 parts by weight<br>8 to 30 parts by weight<br>2 to 15 parts by weight |

The adhesive layer made of the composition composed of the above main ingredients (I), (II) and (III) can obtain most preferable adhesive properties, excellent heat resistant, and the like.

If the content of each ingredient is out of the above range, the following problems may arise. If the content of the epoxy resin is less than 3 weight parts, adhesive strength of the layer is decreased. On the contrary, if it exceeds 100 weight parts, heat resistance of the layer may be decreased. If the content of the accelerator or curing agent is less than 0.5 weight parts, the epoxy resin is not cured. On the contrary, if it exceeds 50 weight parts, heat resistance is decreased.

An excellent adhesive agent having low water absorption and low-temperature bonding property can be obtained by using the polyimide resin of the present invention as a constituent of a composition of an adhesive agent.

The polyimide resin of the present invention has an excellent heat resistance and low water absorption. By mixing this polyimide resin with epoxy resin, the composition of the present invention can further obtain excellent adhesive properties.

When the diamine having a hydroxyl group represented by the chemical formula (6) is introduced into the polyimide resin, a cross-linking reaction proceeds by reacting the hydroxyl group with epoxy resin, and thereby an excellent PCT resistance is provided to the composition of the present invention.

A cured composition contains 3 wt% or less of residual volatile, preferably 2 wt% or less, and more preferably 1 wt% or less.

The residual volatile can be measured by a chromatographic method, for example. In order to determine the residual volatile, the cured composition is prepared as follows.

① An adhesive agent is cast over a glass plate, and dried at 100°C for 10 minutes. Then it is peeled from the glass plated and fixed to an iron frame. It is dried at 150°C for 20 minutes, and thus a 25-μm-thick sheet is obtained.
② The above-obtained sheet is sandwiched between a polyimide film (APICAL 50AH available from Kaneka Corporation) and a 25-μm-thick copper foil, and then heated at 200°C under a pressure of 3 MPa for 20 minutes. Thus, a copper clad laminate is produced.
③ A cured adhesive material in this laminate is dissolved in a solvent which is not contained in the cured material to prepare a sample solution containing a controlled concentration (for example, 5 wt%) of the cured material. The sample solution is vaporized in a carrier gas, and then the weight of a residual volatile is measured by an FID (flame ionization detector) or the like.

In this case, various concentrations of sample solutions may be prepared in advance by dissolving respective potential solvents in a solvent which is not contained in the cured material. Each sample solution may be vaporized in a carrier gas in a gas chromatography column, and then a calibration curve is prepared to easily measure the weight of a residual volatile by the FID or the like.

When the composition is used as an adhesive agent, for example, as a flexible copper clad laminate, adhesive strength increases by reducing the residual volatile. For example, it becomes possible that retention of peeling strength of the composition is preferably 60 % or higher, more preferably 70 % or higher, and most preferably 80 % or higher after conducting a PCT test (pressure cooker test) which is a reliability test for electronic materials.

Also, it becomes possible that the composition preferably has an excellent low water absorption of 1.5 % or lower, more preferably 1.3 % or lower, and most preferably 1.0 % or lower when the composition of the present invention is cured.

The composition having low water absorption can keep its adhesive strength without swelling under high temperature and humidity.

In the same manner as the residual volatile content was measured, a cured material in a laminate can be used for measuring water absorption.

A water absorption of this adhesive cured material in the laminate can be measured by any known method.

For example, it can be calculated from the results of measurement in accordance with the ASTM D570. Specifically, where the weight of the above cured material after drying at 150°C for 30 minutes is $W_1$ and the weight of the cured material which is soaked in a distilled water for 24 hours and then wiped is $W_2$, water absorption can be calculated as follows:

$$\text{Water absorption (\%)} = (W_2 - W_1) \div W_1 \times 100$$

Water absorption of the composition according to the present invention can be easily adjusted by adjusting compounding ratio of constituents.

A conventional adhesive agent of polyimide resin does not have sufficient adhesive strength to a metal such as a copper foil and a resin film such as polyimide resin. In addition, it is difficult to mix a conventional adhesive agent of polyimide resin with epoxy resin because it has a low degree of solubility in epoxy resin. On the contrary, the composition of the present invention has a good adhesive strength to a metal foil such as copper foil and polyimide film. Further, the composition of the present invention has a high degree of solubility in an organic solvent, so that it has a high workability.

The composition of the present invention can be used in various ways on the basis of knowledge of those skilled in the art. For example, an organic solvent of the composition containing an epoxy resin and the polyimide resin obtained by imidizing a polyamide acid polymer can be used in a sheet-like state or in the state of varnish. Further, a solution of the composition containing polyimide resin and epoxy resin can be solidified and then dissolved in an organic solvent to use as a varnish.

Also, the composition of the present invention can be formed into a sheet in advance to use it as an adhesive sheet. Further, the composition of the present invention can be impregnated into a glass cloth, glass mat, aromatic polyamide cloth, aromatic polyamide mat or the like as a varnish and then semi-cured to use it as a fiber-reinforced adhesive sheet.

In a preferred embodiment, the composition of the present invention can contain at least one kind of solvent and can be used as a varnish. The solvent used herein is not particularly limited as far as it dissolves polyimide resin and epoxy resin. A preferable solvent is an organic polar solvent which is to be used for preparing a polyamide acid solution. Examples of a polyamide acid solution include: sulfoxide solvents such as dimethyl sulfoxide and diethyl sulfoxide; formamide solvents such as N,N-dimethylformamide and N,N-diethylformamide; acetamide solvents such as N,N-dimethylacetamide and N,N-diethylacetamide; pyrrolidone solvents such as N-methyl-2-pyrrolidone; phenol solvents such as phenol, *o*-cresol, *m*-cresol, *p*-cresol, xylenol, phenol halide, and catechol; hexamethylphosphoramide; and γ-butyrolactone. If necessary, these organic polar solvents can be used in combination with an aromatic hydrocarbon such as xylene and toluene. However, solvents are not particularly limited thereto.

Preferable amount and kinds of solvents are used so that the composition contains only 3 wt% or less of residual volatile after curing. From the economic and workable point of view, preferable solvent is a low-boiling solvent having a boiling point of 160°C or lower. The term "low-boiling solvent" used herein is a solvent having a boiling point of 160°C or lower. Preferably, the solvent has a boiling point of 130°C or lower, and more preferably, solvent has a boiling point of 105°C or lower.

Further, the composition of the present invention can be obtained by dissolving the above-obtained soluble polyimide, epoxy resin, and curing agent in an organic solvent containing cyclic ether. Since the solvent can be removed from such composition by drying at a relatively low temperature, the composition exhibits high adhesive strength when it is laminated in a later step. Preferably, examples of such low-boiling solvent include: tetrahydrofuran (hereinafter referred to as "THF", boiling point: 66°C); 1,4-dioxane (hereinafter referred to as "dioxane", boiling point: 103°C); 1,2-dimethoxyethane (boiling point: 84°C) and 1,3-dioxolane (boiling point: 76°C). These solvents can be used alone or in combination.

Examples of a preferable cyclic ether solvent include: tetrahydrofuran (THF), 1,4-dioxane, and 1,3-dioxolane. If the cyclic ether solvent is mixed with a plurality of solvents, it is preferable to mix the solvent with polar organic solvents. When the organic solvent contains 30 wt% or more of cyclic ether solvents, and more preferably 50 wt% or more, the effects of the present invention are easily produced. Examples of the polar organic solvent to be mixed with the cyclic ether solvent include: sulfoxide solvents such as dimethyl sulfoxide and diethyl sulfoxide; formamide solvents such as N,N-dimethylformamide and N,N-diethylformamide; and acetamide solvents such as N,N-dimethylacetamide and dimethylacetamide.

In general, almost all the thermoplastic polyimide resins are insoluble or have a low degree of solubility in these solvents. However, the thermoplastic polyimide of the present invention is soluble in these solvents since an acid dianhydride residue in a molecule of the thermoplastic resin of the present invention is an ester acid dianhydride residue represented by the general formula (1)

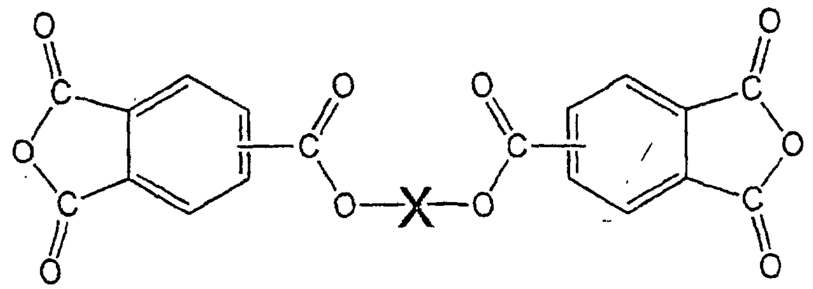

(1)

(wherein X indicates a bivalent organic group having $-(CH_2)_k-$ or an aromatic group and k is an integer of 1 to 10).

The concentration of the organic solvent solution of the composition according to the present invention is 5 to 50 wt%, preferably 10 to 40 wt%, and more preferably 15 to 30 wt%, as a percentage of a weight of a solid content (thermoplastic polyimide + epoxy rein + curing agent) over an weight of the solution. A proper dissolving procedure may be determined by its workability.

The above-obtained composition and even the above-obtained solution of the composition exhibit excellent low water absorption of preferably 1.5 % or less, more preferably 1.3 % or less, and most preferably 1.0 % after it is cured. Further, the content of residual volatile in the cured composition can be reduced to 3 % or less, preferably 2 % or less, and more preferably 1 % or less.

When the polyimide resin contains a hydroxyl group, a cross-linking reaction between the hydroxyl group and epoxy resin proceeds. Therefore, the composition can preferably exhibit a peeling strength retention of 60 % or more, more preferably 70 % or more, and most preferably 80 % or more after conducting a PCT test (pressure cooker test). In addition, the composition is excellent in solder heat resistance, heat resistance, and adhesive strength. Furthermore, when the composition is used as an adhesive agent, it can exhibit sufficient adhesive strength at a relatively low temperature, for example, at 250°C or less.

The above-obtained composition of the present invention is dissolved in an organic solvent, applied to at least one surface of a polyimide film, for example, and then dried. Alternatively, after the composition is applied to a base and then dried, it is peeled from the base and then used as a bonding sheet. Further, the composition can be laminated to a metal foil such as a copper foil, aluminum foil, and 42K alloy foil, polyimide film, or printed circuit board by thermocompression. In this case, the kind of the polyimide film which is used as a core layer is not particularly limited.

Next, a bonding sheet of the present invention will be described. The bonding sheet of the present invention comprises at least an adhesive layer. This adhesive layer is made of the composition of the present invention containing epoxy resin and soluble polyimide having a solubility of 10 % or higher at 20°C in an organic solvent such as N, N-dimethylformamide, 1,4-dioxane, 1,3-dioxolane, and tetrahydrofuran. The bonding sheet of the present invention may be a single-layer of adhesive, or a laminated sheet in which the adhesive layer is formed on a plastic film, metal foil, or the like.

A method of producing the bonding sheet of the present invention is not particularly limited. Specifically, the bonding sheet of the present invention can be produced by:

(1) casting or applying the aforementioned solution of the composition prepared by dissolving the above soluble polyimide and epoxy resin in an organic solvent over a plastic film or a metal support, drying it, and then peeling it from the film or support; or

(2) casting or applying the aforementioned solution of the composition prepared by dissolving the above soluble polyimide and epoxy resin in an organic solvent over at least one surface of a polytmide film, drying it, and thus obtaining a polyimide film-base laminate having an adhesive surface layer of polyimide film.

The bonding sheet obtained in the former case is a single-layer polyimide adhesive film. By laminating this film to a plastic film, a film-like laminate having a similar structure to the latter case can be produced.

As stated above, typical is a method of dissolving the composition in an organic solvent, casting or applying the composition solution over a support, and then heating it to remove the solvent therefrom. However, a solution of polyamide acid which is equivalent to the soluble polyimide, epoxy resin, and other additives can be cast or applied over a support and then heated to dry and imidize the solvent. An optimum heating temperature and heating time vary depending on the resin composition. Therefore, the optimum temperature and time may be determined by experiment.

A method of casting or applying the composition over the base is not limited. The composition can be cast or applied using a known coater such as bar coater, die coater, roll coater, knife coater, and spin coater. The cast or applied composition preferably has a thickness of 3 to 10 μm as an adhesive layer after drying.

Examples of the base include a metal belt, metal drum, and plastic film.

The polyimide adhesive layer according to the present invention, as a surface layer of a laminated bonding sheet having a core layer of polyimide film or as a single-layer bonding sheet of adhesive, has preferably a thickness of 5 to 30 μm. When the adhesive layer is too thin, adhesive strength decreases. When the adhesive layer is too thick, the organic solvent may be hard to be reduced or the evolution of bubbles may occur on its surface.

The bonding sheet of the present invention comprises a plastic film as a core layer and/or release film layer. In this case, a plastic film is used as a base, and an adhesive layer is applied over the base and dried. The adhesive layer is not peeled from the base, but is rolled up.

The plastic film to be used as the core layer is preferably a polyimide film. The plastic film to be used as a release film is preferably a film which is mainly composed of PET (polyethylene terephthalate) or PEN (polyethylene naphthalate).

When a method of peeling the composition from a base is adopted, the obtained single-layer film is, for example, sandwiched between two release films to produce a three-layer bonding sheet composed of a release film, an adhesive agent, and another release film. The bonding sheet can be formed into sheet or can be produced as a continuous roll, for example.

A technique of laminating a release film and a film-like adhesive agent is not particularly limited. Examples of a preferable laminating technique include a thermal pressing, vacuum pressing, autoclave pressing, heat roll pressing, and inch pressing. From the technical stand point, more preferable are a heat roll pressing technique and an inch pressing technique for pressing a continuous film.

The bonding sheet of the present invention is a single-layer sheet or a laminated sheet in which adhesive layers are formed on a plastic film (core layer). However, the bonding sheet of the present invention can be laminated to a metal foil, another film, printed circuit board, or the like by thermocompression. Examples of a metal foil include a copper foil, aluminum foil, and 42 alloy. The kinds of the film (core layer) are not particularly limited. Examples of the film include a polyimide film and a polyester film. A conventional polyimide adhesive agent does not have sufficient adhesive strength to a metal such as a copper foil and a resinous film such as polyimide film, and is hard to blend with epoxy resin due to low solubility. However, the bonding sheet of the present invention has a sufficient adhesive strength to a metal such as a copper foil and a resinous film such as polyimide film, and can be bonded at a low temperature. Thus, the bonding sheet of the present invention is excellent in workability.

For example, the surface of the adhesive layer of the bonding sheet is thermally pressed to a metal foil or polyimide film at a heating temperature of 150°C to 250°C at a pressure of 0.1 to 10 MPa for a heating time of about 5 to 20 minutes.

Preferable water absorption of the adhesive layer (soluble polyimide) of the above bonding sheet having an adhesive layer containing the soluble polyimide resin and epoxy resin is preferably 2.0 % or less, and more preferably 1.5 % or less, and most preferably 1.0 %. Within this range, the soluble polyimide can be preferably used as an adhesive agent in a field of electronic material. The use of such soluble polyimide resin having low water absorption makes it easy to obtain electronic circuit board having excellent dielectric properties. A glass transition temperature of the soluble polyimide can be 120°C or higher, preferably 150°C or higher, and more preferably 160°C or higher. If the polyimide is used as a substrate material which is to be heated in a solder reflow reactor at a temperature in the neighboring of 240°C, it is important that the polyimide has a glass transition temperature of 160°C or more. Such polyimide can be preferably used.

The above soluble polyimide resin preferably has a solubility of 10 % or higher at 20°C in an organic solvent such as N, N-dimethylformamide, 1,4-dioxane, 1,3-dioxolane, and tetrahydrofuran, and more preferably 15 % or higher, and most preferably 20 % or higher in view of production cost and efficiency.

Further, if the adhesive layer is cured, a residual volatile left in the cured layer can be 3 wt% or less of the total weight of the cured layer, preferably 2 wt% or less, and more preferably 1 wt% or less. A water absorption of the cured layer is preferably 1.5 % or less, more preferably 1.3 % or less, and most preferably 1.0 % or less. Thus the cured layer can exhibit excellent low water absorption.

The bonding sheet of the present invention has suitable properties for a TAB tape, composite lead frame, laminating material, or the like. Specifically, the bonding sheet of the present invention has low water absorption, excellent solder heat resistance, excellent heat resistance, and excellent adhesive properties, and can be used as an adhesive agent at 250°C or less.

Next, an adhesive laminated film for covering an accelerator beam tube is composed of a polyimide film and an adhesive layer.

Although a composition of the polyimide film to be used as a base is not particularly limited, the thickness of the polyimide is preferably 5 to 300 μm and more preferably 10 to 125 μm. The thickness of the adhesive layer is preferably 1 to 20 μm, and more preferably 3 to 15 μm.

The adhesive layer laminated on the polyimide film contains the above soluble polyimide having a glass transition temperature of 100°C to 250°C, and water absorption of 1.5 % or less, and is further composed of a composition containing thermosetting resin.

The soluble polyimide contained in the adhesive layer has low water absorption, which is preferably 1.5 % or less, more preferably 1.2 % or less, and most preferably 1.0 % or less. If water absorption exceeds 1.5 %, the polyimide film and the adherend tend to be deteriorated due to water absorption. The term "water absorption" used herein is a value obtained by measuring a 25-μm-thick soluble polyimide film.

A glass transition temperature of the soluble polyimide is preferably 130°C to 240°C, more preferably 150°C to 200°C. When the laminated film is heated, heat sealing of the soluble polyimide and curing reaction of the thermosetting resin are accelerated. Therefore, where a glass transition temperature of the soluble polyimide exceeds 250°C, an adherend may be deteriorated due to high-temperature heat sealing. On the contrary, where a glass transition temperature of the soluble polyimide is less than 100°C, the adhesive layer melts out when it is heated at a high temperature.

When a wire rod or the like is covered with a laminated film having an adhesive layer made of only polyimide, a glass transition temperature of the polyimide must be 60°C to 70°C higher than that of a conventional polyimide adhesive layer. Otherwise, the laminated film is not adhered to the wire rod.

However, an accelerator beam tube is made of superconducting wire such as a Ti-Nb system. When the beam tube is exposed to an atmosphere having a certain temperature or more, it is deteriorated by heat and thereby superconductivity of the tube is spoiled. Therefore, a temperature higher than a glass transition temperature of the polyimide may deteriorate physical properties of the beam tube. Alternatively, resin flow may occur by heat and continuity of liquid helium which is used for cooling the wire rod is interrupted. As a result, the wire rod is difficult to cool down and the superconductivity of the wire rod is spoiled.

Since the adhesive laminated film for covering an accelerator beam tube contains thermosetting resin and the soluble polyimide which is used as an adhesive layer, the film can be bonded at a heating temperature in the neighboring of a glass transition temperature of the polyimide, and the resin flow and the deterioration of the superconductivity of the wire rod can be prevented. Therefore, the adhesive film is particularly preferably used for covering an accelerator beam tube. Although any of the above listed thermosetting resins can be used, a preferable thermosetting resin is epoxy resin. Particularly, as listed above, epoxy resin having two or more epoxy groups in one molecule is preferably used.

If the content of the polyimide resin is 100 weight parts, the content of the above thermosetting resin, especially epoxy resin, is preferably 1 to 50 weight parts, and more preferably 5 to 30 weight parts. Too less content of thermosetting resin may degrade an adhesive strength, whereas too much content of the thermosetting resin may degrade a radiation resistance.

In order to improve heat resistance and adhesive properties, commonly-used curing agents for thermosetting resin and various coupling agents can be added to the adhesive layer. Examples of curing agents for epoxy resin include acid dianhydrides, amines, imidazoles, or the like. As the thermoplastic resin having the above properties, the above obtained thermoplastic resin of the present invention can be used.

The adhesive layer of the adhesive laminated film for covering an accelerator beam tube according to the present invention contains thermosetting resin, so that it exhibits excellent adhesive properties at a low temperature. Particularly, the above-listed compositions of the present invention are preferably used.

An example of a method of laminating an adhesive laminated layer on a polyimide film is as follows. A polyimide adhesive solution is cast or applied over a support, dried, and then peeled from the support to obtain a bonding sheet of the present invention. The thus-obtained bonding sheet is attached to the polyimide film by thermocompression to obtain a laminated film. In this case, the polyimide film, adhesive layer, and release paper may be attached in this order by thermocompression, and the release paper is pealed off when in use.

The adhesive layer(s) can be attached to one surface or both surfaces of the polyimide film. In many cases, the adhesive laminated film for covering an accelerator beam tube is wound around the tube while overlapping. For this reason, it is preferable to attach the adhesive layers on both surfaces of a polyimide film.

The adhesive laminated film for covering an accelerator beam tube obtained by the aforementioned method is wound around the tube alone, or it is wound around the tube with a film of polyethylene terephthalate, polypropylene, polyethylene or the like, which is provided to the adhesive layer side of the adhesive laminated film as a spacer.

The adhesive layer of the laminated film for covering an accelerator beam tube contains the above obtained soluble polyimide which is a thermoplastic resin having a glass temperature of 100°C to 250°C, preferably 150°C to 200°C. For this reason, when this laminated film is lapped around the accelerator beam tube with the adhesive layer inside and then heated at a temperature in the neighboring of the glass transition temperature, the adhesive laminated film can be bonded to the accelerator beam tube without spoiling superconductivity of the beam tube.

In the present invention, the soluble polyimide resin which is preferably contained in an adhesive layer is obtained by reacting with an ester acid dianhydride represented by the general formula (1). Therefore, the adhesive laminated film for covering an accelerator beam tube exhibits lower water absorption than a conventional polyimide and suffers less performance deterioration due to. water absorption. Further, it has been shown that the laminated film

of the present invention has an excellent radiation resistance.

The adhesive laminated film for covering an accelerator beam tube according to the present invention has excellent adhesive properties, flexibility, and radiation resistance, and suffers less performance deterioration due to water absorption. Such properties are particularly suitable for covering a superconductive accelerator beam tube.

The accelerator beam tube is covered with the adhesive laminated film for covering an accelerator beam tube as follows. FIG. 1 is a sectional view of the laminated film having adhesive layers on both sides according to the present invention. For example, as shown in FIG. 2, a laminated film 10 is spirally wound around an accelerator beam tube 12 while overlapping, and then heated to a predetermined temperature in the neighboring of a glass transition temperature of the soluble polyimide (adhesive layer). As shown in FIG. 4, a polytmide film 16 is thermally attached to the accelerator beam tube 12 through an adhesive layer 14. Alternatively, the laminated film 10 may be spirally wound at intervals, as shown in FIG. 3.

One of the method for covering an accelerator beam tube with an insulating coating is winding an adhesive film and a polyimide film together around the accelerator beam tube and then bonding them by thermocompression. However, as in the case of the laminated film of the present invention, it is preferable that the adhesive layer is laminated to the polyimide film in advance, in terms of workability and productivity.

The adhesive film, which is composed of thermoplastic resin and thermosetting resin, can be used itself as an insulating coating. In this case, the adhesive film is wound around the accelerator beam tube first and then bonded thereto by thermocompression. After that, the release paper may be pealed off.

While the embodiments of the adhesive laminated film for covering an accelerator beam tube according to the present invention have been described, it should be understood that the present invention be not limited to these embodiments. The accelerator beam tube to be covered with the laminated film of the present invention may be a superconductive accelerator beam tube or any other accelerator beam tube.

The adhesive laminated film for covering a conductive wire for an accelerator quench heater is produced by laminating an adhesive layer on a polyimide film. The adhesive layer can be attached to one surface or both surfaces of the polyimide film. In many cases, since the adhesive laminated film for covering an accelerator beam tube is wound around the tube while overlapping, it is preferable to laminate the adhesive layers on both surfaces.

Although the composition of the polyimide film is not particularly limited, the thickness of the polyimide film is preferably 5 to 300 μm, and more preferably 10 to 125 μm. The thickness of the adhesive layer is preferably 1 to 20 μm, and more preferably 3 to 15 μm.

The adhesive layer to be laminated on the polyimide film is made of a composition containing a thermosetting resin and a thermoplastic resin which has a glass transition temperature of 100°C to 250°C and water absorption of 1.5 % or less.

A glass transition temperature of the soluble polyimide is preferably 130°C to 240°C, and more preferably 150°C to 200°C. When laminated films are heated, heat sealing of the soluble polyimide and curing reaction of the thermosetting resin are accelerated. Therefore, where a glass transition temperature of the soluble polyimide exceeds 250° C, an adherend may be deteriorated due to high-temperature heat sealing. On the contrary, where a glass transition temperature of the soluble polyimide is less than 100°C, the adhesive layer melts out when it is heated at a high temperature.

It is desired that the thermoplastic resin contained in the adhesive layer has low water absorption of 1.5 % or less. If water absorption exceeds 1.5 %, the polyimide film and the adherend tend to be deteriorated due to absorbed water. Water absorption is preferably 1.2 % or less, and more preferably 1.0 % or less. The term "water absorption" used herein is a value obtained by measuring a 25-μm-thick soluble polyimide film.

The composition containing the polyimide having the above properties and an epoxy resin according to the present invention is suitably used as the adhesive laminated film for coating a conductive wire for an accelerator quench heater. Such adhesive layer contains a thermoplastic resin and thermosetting resin, so that it exhibits excellent adhesive properties at a low temperature. Specifically, the adhesive layer is a soluble polyimide having a glass transition temperature of 100°C to 250°C and can be obtained by reacting ester acid dianhydride represented by the general formula (1) with a diamine compound or diisocyanate compound represented by the general formula (2). Since the soluble polyimide according to the present invention has lower water absorption than a conventional polyimide, the adhesive laminated film for coating a conductive wire for an accelerator quench heater suffers less performance deterioration due to water absorption.

Although any of the above listed thermosetting resins can be used, a preferable thermosetting resin is epoxy resin. Particularly, as listed above, epoxy resin having two or more epoxy groups in one molecule is preferably used.

If the content of the polyimide resin is 100 weight parts, the content of the above thermosetting resin, especially epoxy resin, is preferably 1 to 50 weight parts, and more preferably 5 to 30 weight parts. Too less content of thermosetting resin may degrade an adhesive strength, whereas too much content of the thermosetting resin may degrade a flexibility or heat resistance.

In order to improve heat resistance and adhesive properties, commonly-used curing agents of thermosetting

resin and various coupling agents can be added to the adhesive layer. Examples of curing agents for epoxy resin include acid dianhydrides, amines, imidazoles, or the like.

Examples of a method of laminating an adhesive layer on a polyimide film include a method in which an adhesive solution is prepared, cast or applied to a polyimide film, and then dried. In the case of purified thermoplastic polyimide resin containing no organic solvent, the polyimide resin can be dissolved with thermosetting resin in an organic solvent again and then filtered so as to produce a purified varnish. The solvent used herein is not particularly limited, but any known organic solvent can be used.

Another example of a method of laminating an adhesive laminated layer on a polyimide film is as follows. The above polyimide adhesive solution is cast or applied over a base, dried, and then peeled from the base to obtain a bonding sheet containing a soluble polyimide and thermosetting resin. The bonding sheet is bonded to the polyimide film (core layer) by thermocompression, and thus a laminated film is obtained. In this case, the polyimide film, adhesive layer, and release paper may be laminated by thermocompression, and the release paper is pealed off when in use.

The adhesive laminated film for covering a conductive wire for an accelerator quench heater obtained by the aforementioned method is wound alone around the tube, or it is wound around the tube with a film of polyethylene terephthalate, polypropylene, polyethylene or the like which is provided to the adhesive layer side of the adhesive laminated film as a spacer.

The adhesive layer of the laminated film for covering a conductive wire for an accelerator quench heater is wound around the conductive wire with the adhesive layer inside, and then heated at a temperature in the neighboring of the glass transition temperature of 100°C to 250°C, preferably 150°C to 200°C. Thus, the adhesive laminated film can be bonded to the conductive wire.

In the present invention, the soluble polyimide resin which is preferably used as thermoplastic resin contained in the adhesive laminated film for covering a conductive wire for a accelerator quench heater according to the present invention can be obtained by reacting ester acid dianhydride represented by the general formula (1) with a diamine or diisocyanate compound represented by the general formula (2). Since the soluble polyimide exhibits lower water absorption than a conventional polyimide, the adhesive laminated film for covering a conductive wire for an accelerator quench heater suffers less performance deterioration due to absorbed water. Further, it has been shown that the laminated film of the present invention has an excellent radiation resistance. Specifically, the adhesive laminated film for covering a conductive wire for an accelerator quench heater according to the present invention has excellent adhesive properties, flexibility, and radiation resistance, and suffers less performance deterioration due to water absorption. Such properties are particularly suitable for covering a superconductive accelerator quench heater or the like.

A conductive wire for an accelerator quench heater is covered by the same method of covering a beam tube as described with reference to FIG. 1 to FIG. 4.

In a conventional method of covering a conductive wire for an accelerator quench heater, an adhesive film layer and a polyimide film are wound together around a conductive wire for an accelerator quench heater and then bonded by thermocompression. However, in the present invention, an adhesive laminated film is laminated to a polyimide film in advance, wound around a conductive wire for an accelerator quench heater, and then attached by thermocompression. Therefore, higher handleability, workability, and productivity are atained by the method of the present invention than the conventional method.

The film-like laminated layer itself, which is composed of thermoplastic resin (adhesive layer) and thermosetting resin, can be used as an insulating coating. In this case, the adhesive film and the release paper are wound together around the accelerator beam tube and then bonded thereto by thermocompression. After that, the release paper may be pealed off.

While the embodiments of the adhesive laminated film for covering a conductor wire for an accelerator quench heater have been described, it should be understood that the present invention be not limited to these embodiments. The conductor wire for an accelerator quench heater to be covered with the laminated film of the present invention may be a conductor wire for a superconductive accelerator beam tube or any conductor wire for an accelerator quench heater including a copper wire. In addition, various changes, modifications, and improvements can be made to the embodiments on the basis of knowledge of those skilled in the art without departing from the scope of the present invention.

## EXAMPLES

The present invention will be more clearly understood by referring to the examples which follow. These examples should not be construed to limit the invention in any way.

In Examples, physical properties are measured as follows.

(a)Solubility

As an organic solvent, N,N-dimethylformamide, 1,4-dioxane, 1,3-dioxolane, and tetrahydrofuran were prepared. 20 g of polyimide was added to 80 g of each organic solvent and stirred sufficiently at 20°C. Then, it was visually checked whether the polyimide was completely dissolved.

(b)Glass transition temperature

Endothermic starting temperature was measured by a differential scanning calorimeter DSC CELL SCC-41 (Shimadzu Corp.) at a heating rate of 10°C/min.. This endothermic temperature was defined as a glass transition temperature. Higher a glass transition temperature, more excellent in heat resistance.

(c)Water absorption

A polyimide solution was cast over a PET (polyethylene terephthalate) film, dried at 100°C for 30 minutes, peeled from the PET film, fixed to a frame with pins, and then dried at 170°C for 30 minutes to produce a polyimide sheet (25 μm). After drying at 150°C for 30 minutes, a weight of the polyimide sheet was measured in accordance with ASTM D-570. Further, after immersing it in distilled water for 24 hours (at 20°C in a 60% RH environment), the sheet was wiped and then the weight thereof was measured.

Water absorption (%) = [(Weight after immersion - weight

after drying) / weight after drying] × 100

(d) Peeling strength

Peeling strength was measured in accordance with JISC6481. Copper foils are bonded using an adhesive agent with the roughened surfaces of the foils facing in, and then thermally pressed to cure the adhesive agent. Using this 5-mm-width sample laminate (copper foil/adhesive agent/copper foil), peeling strength was measured by peeling the copper foil at a speed of 50 mm/min at an angle of 90° .

(e)Solder heat resistance

Copper foils are bonded using an adhesive agent with the roughened surfaces of the foils facing in, and then thermally pressed to cure the adhesive agent. After leaving this sample laminate (copper foil/adhesive agent/copper foil) under normal conditions (at 20°C in a 60% RH environment for 24 hours), it was dipped in a solder bath of 260°C for 10 seconds. After that, the outward appearance of the laminate was checked to see whether it is swelled or not.

Various kinds of polyimides are produced in the following Example 1 to 11 and Comparative examples 1 to 7.

(Example 1)

64.3 g (0.1487 mol) of 3,3'-bis(aminophenoxy phenyl)sulfone (meta type)

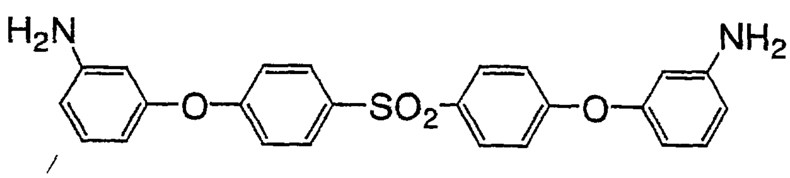

and 280 g of N,N-dimethylformamide (hereinafter referred to as "DMF") were placed in a 500 mL glass flask and then stirred. After dissolving the diamine, 85.7 g (0.1487 mol) of ESDA was gradually added at 25°C under nitrogen atmosphere with care of viscosity to produce a polyamid acid solution having a viscosity of 1500 poise (at 25°C).
150 g of DMF, 35 g of β-picoline, and 60 g of acetic anhydride were added to this polyamide acid solution and stirred for an hour. Then this solution was stirred in a 100°C atmosphere for an hour for imidization. After that, this solution was added dropwise to methanol with stirring at high speed to precipitate thread-like polyimide out of the solution. The

thread-like polyimide was dried for 2 hours at 100°C to produce polyimide powders. A glass transition temperature was 180°C and water absorption was 0.9 %. The solubilities of the polyimide in DMF, 1,4-dioxane (hereinafter referred to as "dioxane"), 1,3-dioxolane (hereinafter referred to as "dioxolane"), and tetrahydrofuran (hereinafter referred to as "THF") were checked, respectively. At the result, it was found that the polyimide had a solubility of 20 % or higher in each of the aforementioned organic solvents.

(Example 2)

A polyimide was produced in the same manner as described in Example 1, with an exception that 4,4'-[1,4-phenylenebis (1-methylethyllidene)] bisaniline:

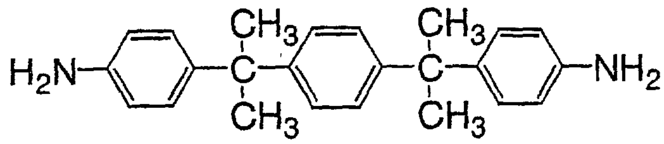

was used as a diamine compound. The polyimide had a solubility of 20% or higher in each organic solvent, a glass transition temperature of 230°C, and water absorption of 0.8%.

(Example 3)

A polyimide was produced in the same manner as described in Example 1, with an exception that 4,4'-[1,3-phenylenebis (1-methylethyllidene)] bisaniline:

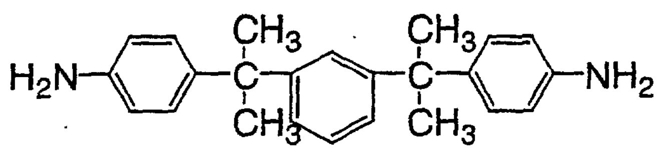

was used as a diamine compound. The polyimide had a solubility of 20% or higher in each organic solvent, a glass transition temperature of 210°C, and water absorption of 0.9%

(Example 4)

A polyimide was produced by heating the polyamide acid obtained in Example 1 at 200°C for 3 hours at a pressure of 0.007 X $10^5$ Pa. The polyimide had a solubility of 20% or higher in each of the aforementioned organic solvents, a glass transition temperature of 180°C, and water absorption of 0.9%.

(Example 5)

280 g of DMF, 0.1487 mol of 4'4-diphenylmethane diisocyanate

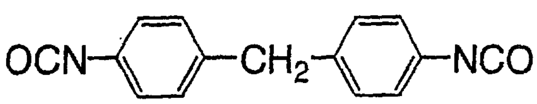

, and 0.1487 mol of ESDA were placed in a 500 mL glass flask and then stirred. The stirred solution was put into a Teflon coated vat and then dried in a vacuum oven at 200°C for 3 hours to produce a polyimide. The polyimide had a solubility of 20% or higher in each of the aforementioned organic solvents, a glass transition temperature of 200°C, and water absorption of 0.8%.

(Example 6)

A polyimide was produced in the same manner as described in Example 1, with an exception that 0.1041 mol of 3,3'-bis(aminophenoxyphenyl)propane (meta type)

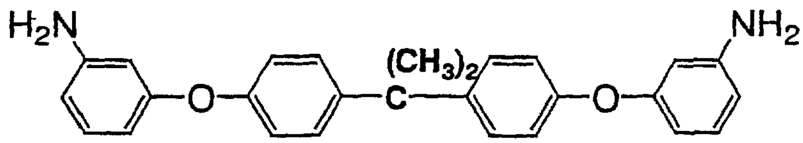

and 0.0446 mol of α,ω-bis(3-aminopropyl)polydimethylsiloxane (APPS) were used as diamine compounds. The polyimide had a solubility of 20% or higher in each organic solvent, a glass transition temperature of 100°C, and water absorption of 1.7%.

(Example 7)

43.5 g (0.1487 mol) of 1,3-bis(3-aminophenoxy)benzene and 201 g of N,N-dimethylformamide (hereinafter referred to as DMF) were placed in a 500 mL of glass flask and then stirred. After dissolving diamine, 64.3 g (0.1487 mol) of ESDA was gradually added at 25°C under nitrogen atmosphere with care of viscosity to produce a polyamid acid solution having a viscosity of 1500 poise (at 25°C). To this polyamide acid solution, 150 g of DMF, 35 g of β-picoline, and 60 g of acetic anhydride were added and stirred for an hour. Then this solution was stirred in a 100°C atmosphere for an hour for imidization. After that, this solution was added dropwise to methanol with stirring at high speed to precipitate thread-like polyimide out of the solution. The thread-like polyimide was dried at 100°C for 30 minutes, crushed with a mixer, extracted by Soxlet method using methanol, and dried at 100°C for 2 hours to produce polyimide. The polyimide had a glass transition temperature of 160°C and water absorption of 0.9 %. The solubilities of the polyimide in DMF, 1,4-dioxane (hereinafter referred to as "dioxane"), and tetrahydrofuran (hereinafter referred to as THF) were checked, respectively. At the result, it was found that the polyimide had a solubility of 20 % or higher in each of the aforementioned organic solvents.

(Example 8)

A polyimide was produced by heating the polyamide acid obtained in Example 7 at 200°C for 3 hours at a pressure of 0.007 X $10^5$ Pa. The polyimide had a solubility of 20% or higher in each of the aforementioned organic solvents, a glass transition temperature of 160°C, and water absorption of 0.9%.

(Example 9)

201 g of DMF, 0.1487 mol of 1,3-bis(3-isocyanatephenoxy)benzene, and 0.1487 mol of ESDA were placed in a 500 mL glass flask and then stirred. The stirred solution was put into a Teflon coated vat and then dried in a vacuum oven at 200°C for 3 hours to produce a polyimide. The polyimide had a solubility of 20% or higher in each of the aforementioned organic solvents, a glass transition temperature of 160°C, and water absorption of 0.9%.

(Example 10)

280 g of dimethylformamide (hereinafter referred to as "DMF"), 0.1338 mol of 3,3-bis(aminophenoxyphenyl) propane (meta type: hereinafter referred to as "BAPP-M"), and 0.0149 mol of 3,3'-dihydroxy-4,4'-diaminobiphenyl (hereinafter referred to as "HAB"; Wakayama Seika Kogyo Co.,Ltd.) were placed in a 500 mL glass flask and then dissolved under a nitrogen atmosphere with stirring. Then, the solution was cooled with stirring in an ice water bath under a nitrogen atmosphere in the flask, and 0.1487 mol of 2,2-bis(4-hydroxyphenyl)propanedibenzoate-3,3',4,4'-tetracarboxylic dianhydride (hereinafter referred to as "ESDA") was gradually added thereto with care of viscosity until the viscosity reached 1500 poise. Thus a polyamide acid polymer solution was produced.

300 g of the polyamide acid solution was put into a Teflon coated vat and then dried in a vacuum oven at 150°C for 10 minutes, 160°C for 10 minutes, 170°C for 10 minutes, 180°C for 10 minutes, 190°C for 10 minutes, and 210°C for 30 minutes under a reduced pressure of 667Pa. When the vat was taken out of the vacuum oven, 85. 4 g of thermoplastic polyimide resin having a hydroxyl group was obtained. The polyimide had a solubility of 20% or higher in each of the aforementioned organic solvents, a glass transition temperature of 210°C, and water absorption of 0.9%.

(Example 11)

A polyimide acid polymer solution was produced in the same manner as described in Example 10, with an exception that 4,4'-(1,3-phenylenebis(1-methylethyllidene))bisaniline (para type) was used as a diamine compound in place of the BAPP-M, and then thermoplastic polyimide resin powders having a hydroxyl group were obtained.
The polyimide had a solubility of 20% or higher in each organic solvent, a glass transition temperature of 210°C, and water absorption of 0.9%.

(Comparative example 1)

A polyimide was produced in the same manner as described in Example 1, with an exception that biphenyl tetracarboxylic dianhydride (BTDA) was used in place of ESDA. Thus-obtained polyimide was insoluble in DMF, dioxane, and THF.

(Comparative example 2)

A polyimide was produced in the same manner as described in Example 1, with an exception that 4,4'-diaminodiphenylther was used in place of a diamine compound. Thus-obtained polyimide was insoluble in DMF, dioxane, and THF.

(Comparative example 3)

280 g of DMF, 0.1338 mol of 3,3'-bis(aminophenoxyphenyl)propane (hereinafter referred to as "BAPP-M") and 0.01487 mol of α,ω-bis(3-aminopropyl) polydimethylsiloxane (APPS) were placed in a 500 mL glass flask and then dissolved under a nitrogen atmosphere with stirring. Then, the solution was cooled in an ice water bath with stirring under a nitrogen atmosphere in the flask, and 0.1487 mol of BTDA was gradually added thereto with care of viscosity until the viscosity reached 1000 poise. Thus a polyamide acid polymer solution was produced.
To the polyamide acid polymer solution, 150 g of DMF, 35 g of β-picoline, and 60 g of acetic anhydride were added and stirred for an hour. It was then further stirred at less than 100°C for an hour for imidization. After that, this solution was added dropwise in methanol with stirring at high speed to precipitate thread-like polyimide out of the solution. The thread-like polyimide was dried at 100°C for 30 minutes, crushed with a mixer, extracted by Soxlet method using methanol, and dried at 100°C for 2 hours to produce polyimide powders. The polyimide powders were insoluble in DMF, 1,4dioxane, and THF, respectively.

(Comparative example 4)

A polyimide was produced in the same manner as described in Example 7, with an exception that biphenyl tetracarboxylic dianhydride (BTDA) was used in place of ESDA. Thus-obtained polyimide was insoluble in DMF, dioxane, and THF, respectively.

(Comparative example 5)

280 g of dimethylformamide (hereinafter referred to as "DMF"), 0.1338 mol of 3,3'-bis(aminophenoxyphenyl) propane (meta type: hereinafter referred to as "BAPP-M), and 0.0149 mol of HAB (Wakayama Seika Kogyo Co.,Ltd.) were placed in a 500 mL glass flask and then dissolved under a nitrogen atmosphere with stirring. Then, the solution was cooled with an ice water bath with stirring under a nitrogen atmosphere in the flask, and 0.1487 mol of 2,2-bis (4-hydroxyphenyl)propanedibenzoate-3,3',4,4'-tetracarboxylic dianhydride (hereinafter referred to as "ESDA") was gradually added thereto with care of viscosity until the viscosity reached 1500 poise. Thus a polyamide acid polymer solution was produced.
300 g of the polyamide acid solution was put into a Teflon coated vat and then dried in a vacuum oven at 150°C for 10 minutes, 160°C for 10 minutes, 170°C for 10 minutes, 180°C for 10 minutes, 190°C for 10 minutes, and 210°C for 30 minutes under a reduced pressure of 667Pa. When the vat was taken out of the vacuum oven, 85.4 g of thermoplastic polyimide resin having a hydroxyl group was obtained. The polyimide had a solubility of 20% or higher in each of the aforementioned organic solvents, a glass transition temperature of 210°C, and water absorption of 0.8%.

(Comparative example 6)

280 g of dimethylformamide (hereinafter referred to as "DMF") and 0.1487 mol of 3,3'-bis(aminophenoxyphenyl)propane (meta type: hereinafter referred to as "BAPP-M") were placed in a 500 mL glass flask and then dissolved under a nitrogen atmosphere with stirring. Then, the solution was cooled with an ice water bath with stirring under a nitrogen atmosphere in the flask, and 0.1487 mol of 2,2-bis(4-hydroxyphenyl)propanedibenzoate-3,3,'4,4'-tetracarboxylic dianhydride (hereinafter referred to as "ESDA") was gradually added thereto with care of viscosity until the viscosity reached 1500 poise. Thus a polyamide acid polymer solution was produced.

The polyamide acid polymer solution was heated under a reduced pressure in the same manner as described in Example 1 to produce a thermoplastic polyimide resin powders. Thus-obtained polyimide had a solubility of 20% or higher in each of the aforementioned organic solvents, a glass transition temperature of 190°C, and water absorption of 0.8%.

(Comparative Example 7)

280 g of dimethylformamide (DMF), 0.1487 mol of 3,3'-bis(aminophenoxyphenyl)propane (hereinafter referred to as "BAPP-M") were placed in a 500 mL glass flask and then dissolved under a nitrogen atmosphere with stirring. Then, the solution was cooled in an ice water bath with stirring under a nitrogen atmosphere in the flask, and 0.1487 mol of BTDA was gradually added thereto with care of viscosity until the viscosity reached 1500 poise. Thus a polyamide acid polymer solution was produced.

To the polyamide acid polymer solution, 150 g of DMF, 35 g of β-picoline, and 60 g of acetic anhydride were added and stirred for an hour. It was then further stirred at less than 100°C for an hour for imidization. After that, this solution was added dropwise in methanol with stirring at high speed to precipitate thread-like polyimide out of the solution. The thread-like polyimide was dried at 100°C for 30 minutes, crushed with a mixer, extracted by Soxlet method using methanol, and dried at 100°C for 2 hours to produce polyimide powders. The polyimide powders had a solubility of 20% or higher in each of the aforementioned organic solvents, a glass transition temperature of 220°C, and water absorption of 1.8%.

In each of the following Examples 12 to 17 and Comparative examples 8 to 14, a copper clad laminate in which a polyimide composition was used as an adhesive layer was produced, and the physical properties thereof were measured.

(Example 12)

20 g of polyimide resin powders obtained in Example 10, 5 g of novolac epoxy resin Epikote 1032H60 (Yuka Shell Epoxy Co.,Ltd.), and 0.015 g of 4,4'-diaminodiphenylsulfone (hereinafter referred to as "4,4'-DDS") as a curing agent were dissolved in 83 g of a mixed solvent of dioxane and THF (weight ratio of 1:1) to produce a polyimide composition (varnish) according to the present invention. The varnish was cast over a glass plate, dried at 100°C for 10 minutes, peeled from the glass plate, fixed to an iron frame, and then dried at 150°C for 20 minutes to produce a 25-μm-thick sheet. Thus-obtained sheet was sandwiched between a polyimide film APICAL 50 AH (Kaneka Corporation) and a 25-μm-thick copper foil and then dried at 200°C for 20 minutes at a pressure of 3MPa. Thus a flexible copper clad laminate was produced.

(Example 13)

The varnish obtained in Example 10 was applied to a polyimide film APICAL 50 AH (Kaneka Corporation) and dried at 100°C for 10 minutes and at 150°C for 20 minutes to produce a 25-μm-thick adhesive layer. Thus-obtained polyimide film with the adhesive layer on one side thereof was heated at 200° C for 20 minutes at a pressure of 3MPa. Thus a flexible copper clad laminate was produced.

(Example 14)

20 g of the polyimide resin powders obtained in Example 10 and 5 g of glycidylamine epoxy resin TETRAD-C (MITSUBISHI GAS CHEMICAL COMPANY, INC.) was dissolved in 83 g of mixed solvent of dioxane and THF (weight ratio of 1:1). Thus-obtained varnish was cast over a glass plate, dried at 100°C for 10 minutes, peeled from the glass plate, fixed to an iron frame, and then dried at 150°C for 20 minutes to produce a 25-μm-thick sheet. Thus-obtained sheet was sandwiched between a polyimide film APICAL 50 AH (Kaneka Corporation) and a 25-μm-thick copper foil and then dried at 200°C for 20 minutes at a pressure of 3MPa. Thus a flexible copper clad laminate was produced.

(Example 15)

In the same manner as described in Example 12, a composition solution was obtained from the soluble polyimide resin powders obtained in Example 11, and a flexible copper clad laminate was produced from the composition solution.

(Example 16)

In the same manner as described in Example 12, a composition solution was obtained from the soluble polyimide resin powders obtained in Example 7, and a flexible copper clad laminate was produced from the composition solution.

(Example 17)

In the same manner as described in Example 12, a composition solution was obtained from the soluble polyimide resin powders obtained in Example 1, and a flexible copper clad laminate was produced from the composition solution.

(Comparative example 8)

20 g of polyimide resin powders obtained in Example 6, 5 g of novolac epoxy resin Epikote 1032H60 (Yuka Shell Epoxy Co.,Ltd.), and 0.015 g of 4,4'-diaminodiphenylsulfone (hereinafter referred to as "4,4'-DDS") as a curing agent were dissolved in 83 g of a mixed solvent of dioxane and THF (weight ratio of 1:1) to produce a resinous composition (varnish). The varnish was cast over a glass plate, dried at 100°C for 10 minutes, peeled from the glass plate, fixed to an iron frame, and then dried at 150°C for 20 minutes to produce a 25-μm-thick sheet. Thus-obtained sheet was sandwiched between a polyimide film APICAL 50AH (Kaneka Corporation) and a 25-μm-thick copper foil and then dried at 200°C for 20 minutes at a pressure of 3MPa. Thus a flexible copper clad laminate was produced.

(Comparative example 9)

20 g of polyimide resin powders obtained in Example 7, 5 g of Epikote 1032H60 (Yuka Shell Epoxy Co.,Ltd.), and 0.015 g of 4,4'-DDS were dissolved in 83 g of DMF. The varnish was cast over a glass plate, dried at 100°C for 10 minutes, peeled from the glass plate, fixed to an iron frame, and then dried at 150°C for 20 minutes to produce a 25-μm-thick sheet. Thus-obtained sheet was sandwiched between a polyimide film APICAL 50 AH (Kaneka Corporation) and a 25-μm-thick copper foil and then dried at 200°C for 20 minutes at a pressure of 3MPa. Thus a flexible copper clad laminate was produced.

(Comparative example 10)

A copper clad laminate was produced in the same manner as described in Comparative example 6, with an exception that the polyimide resin powders obtained in Comparative example 6 was dissolved in mixed solvent of dioxane and THF (weight ratio of 1:1).

(Comparative example 11)

20 g of polyimide resin powders obtained in Example 6 was dissolved in 83 g of DMF to prepare a varnish. The varnish was cast over a glass plate, dried at 100°C for 10 minutes, peeled from the glass plate, fixed to an iron frame, and then dried at 150°C for 20 minutes to produce a 25-μm-thick sheet. Thus-obtained sheet was sandwiched between a polyimide film APICAL 50AH (Kaneka Corporation) and a 25-μm-thick copper foil, and then dried at 200°C for 20 minutes at a pressure of 3MPa. Thus a flexible copper clad laminate was produced.

(Comparative example 12)

10 g of PLATABOND M1276 (copolymer resin available from Japan Rirusan Company), 20 g of Epikote 1032H60 (Yuka Shell Epoxy Co.,Ltd.), and 1 g of diaminodiphenylsulfone were dissolved in 83 g of DMF to prepare a varnish. The varnish was cast over a glass plate, dried at 100°C for 10 minutes, peeled from the glass plate, fixed to an iron frame, and then dried at 150°C for 20 minutes to produce a 25-μm-thick sheet. Thus-obtained sheet was sandwiched between a polyimide film APICAL 50AH (Kaneka Corporation) and a 25-μm-thick copper foil and then dried at 200°C for 20 minutes at a pressure of 3MPa. Thus a flexible copper clad laminate was produced.

(Comparative example 13)

In the same manner as described in Comparative example 12, a flexible copper clad laminate was produced with an exception that Platabond M1276, Epikote 1032H60, and diaminodiphenylsulfone were dissolved in a mixed solvent of dioxane and THF (weight ratio of 1:1).

(Comparative example 14)

Polyimide resin powders were obtained in the same manner as described in Comparative example 8, with an exception that pyromelletic dianhydride (PMDA) and oxydianiline (ODA) were used in place of acid dianhydride and a diamine compound, respectively.

The polyimide resin powders were dissolved in any solvents of DMF, THF, dioxane, and dioxolane. Neither a composition nor a flexible copper clad laminated could be produced from the polyimide resin powders.

The peeling strength and solder heat resistance of flexible copper clad laminates obtained in Examples 12 to 17 and Comparative examples 8 to 13 were evaluated. Also, water absorption of each adhesive sheet was evaluated as well. Results were shown in Table 1.

In the present invention, the physical properties of a composition was measured as follows.

(a)Measurement of peeling strength

Peeling strength was measured in accordance with JISC 6481. To check solder heat resistance, the appearance of each laminate was evaluated after dipping the laminate in a solder bath at 260°C for 10 seconds. In Table, the mark "○" indicates that it was in a good condition and has no swelling part.

PCT test (Pressure Cooker Test) for assessing reliability of materials for electronics was conducted at 121°C at a humidity of 100% for 96 hours.

(b)Retention of peeling strength after PCT test

Retention of peeling strength was calculated by the following expression, wherein $F_1$ indicates a peeling strength of a laminate before PCT test and $F_2$ indicates a peeling strength of the laminated after PCT test.

$$\text{Peeling strength after PCT test(\%)} = F_2 \div F_1 \times 100$$

(c)Rate of water absorption

The rate of water absorption was determined in accordance with ASTM D570 and calculated by the following expression, wherein $W_1$ is a weight of a cured composition which was dried at 150°C for 30 minutes and $W_2$ is a weight of the composition which was immersed in distilled water for 24 hours and then wiped with a dry cloth.

$$\text{The rate of water absorption(\%)} = (W_2 - W_1) \div W_1 \times 100$$

(d)Residual volatile content

A residual volatile content in a cured composition was determined by gas chromatography. Measurement conditions were as follows.

(Measurements conditions)

Device: Chem Station (Hewlett-Packard Company)
Carrier gas: herium
Column: HP-Wax Bonded Polyethylene Glycol (Hewlett-Packard Company)
Carrier flow: 45 ml/min
Detector: FID

A residual volatile content was calculated by the following expression, wherein $W_3$ indicates a weight of a resinous composition and $W_4$ indicates a weight of the residual volatile which is determined by gas chromatography.

$$\text{Residual volatile content (wt\%)} = W_4 \div W_3 \times 100$$

Table 1

TABLE 1

| | Peeling strength (before PCT test) (kgf/cm) | | Peeling strength (after PCT test) (kgf/cm) | | Retention of peeling strength after PCT test (%) | | Solder heat resistance | Water absorption (%) | Residual volatile content (wt%) |
|---|---|---|---|---|---|---|---|---|---|
| | 20°C | 150°C | 20°C | 150°C | 20°C | 150°C | | | |
| Example 12 | 1.0 | 1.0 | 0.9 | 0.8 | 90 | 80 | ○ | 0.5 | 0.3 |
| Example 13 | 1.0 | 1.0 | 0.9 | 0.8 | 90 | 80 | ○ | 0.5 | 0.2 |
| Example 14 | 1.1 | 1.1 | 1.0 | 0.8 | 91 | 73 | ○ | 0.6 | 0.5 |
| Example 15 | 1.0 | 1.0 | 0.9 | 0.8 | 90 | 80 | ○ | 0.6 | 0.5 |
| Example 16 | 1.0 | 1.0 | 0.9 | 0.8 | 90 | 80 | ○ | 0.6 | 0.5 |
| Example 17 | 1.0 | 1.0 | 0.9 | 0.8 | 90 | 80 | ○ | 1.0 | 0.7 |
| Comparative example 8 | 1.0 | 0.8 | 0.5 | 0.3 | 50 | 38 | × | 0.5 | 3.0 |
| Comparative example 9 | 1.0 | 0.8 | 0.3 | 0.2 | 30 | 25 | × | 1.8 | 3.5 |
| Comparative example 10 | 1.0 | 0.8 | 0.5 | 0.3 | 50 | 38 | ○ | 0.5 | 0.5 |
| Comparative example 11 | 0.2 | 0.1 | 0.0 | 0.0 | 0 | 0 | × | 0.4 | 3.8 |
| Comparative example 12 | 1.2 | 0.1 | 0.3 | 0.0 | 25 | 0 | × | 2.0 | 3.7 |
| Comparative example 13 | 1.2 | 0.1 | 0.5 | 0.0 | 42 | 0 | ○ | 0.5 | 1.5 |

In the following Examples 18 to 20 and comparative examples 15 to 20, the polyimide compositions were dissolved in various kinds of organic solvents and then laminated on a polyimide film to produce bonding sheets . The physical properties of each bonding sheet was measured.

(Example 18)

20 g of the polyimide powders obtained in Example 1, 5 g of Epikote 1032H60 (Yuka Shell Epoxy Co.,Ltd.), and 1.5 g of 4,4'-diaminodiphenylsulfone (curing agent) were added to 102 g of THF and dissolved with stirring to produce a composition solution of the present invention (solids concentration: SC=20%)

(Example 19)

A composition solution was produced in the same manner as described in Example 18, with an exception that 1,4-dioxane was used as an organic solvent instead of THF. (solids concentration: SC=20%)

(Example 20)

A composition solution was produced in the same manner as described in Example 18, with an exception that dioxolane was used as an organic solvent instead of THF. (solids concentration: SC=20%)

(Comparative example 15)

A composition solution was produced in the same manner as described in Example 18, with an exception that dimethylformamide (DMF) was used as an organic solvent instead of THF. (solids concentration: SC=20%)

(Comparative example 16)

A composition solution was produced in the same manner as described in Example 1, with an exception that N-methylpyrrolidone (NMP) was used as an organic solvent instead of THF. (solids concentration: SC=20%)

(Comparative example 17)

A composition solution was produced in the same manner as described in Example 1, with an exception that dimethylacetamide (DMAc) was used as an organic solvent instead of THF. (solids concentration: SC=20%)

(Comparative example 18)

A composition solution was tried to be produced in the same manner as described in Example 1, with an exception that methyl ethyl ketone (MEK) was used as an organic solvent instead of THF. However, the ingredients were not completely dissolved in the organic solvent.

(Comparative example 19)

A composition solution was tried to be produced in the same manner as described in Example 1, with an exception that methanol was used as an organic solvent instead of THF. However, the ingredients were not completely dissolved in the organic solvent.

(Comparative example 20)

A composition solution was tried to be produced in the same manner as described in Example 1, with an exception that ethanol was used as an organic solvent instead of THF. However, the ingredients were not completely dissolved in the organic solvent.

(Examples 18a, 18b, and 18c)

The composition solution obtained in Example 18 was cast over 25-µm-thick polyimide film (APICAL 25AH available from Kaneka Corporation) and dried at 100°C for 10 minutes.
After that, it was heated at 180°C for 10 minutes in Example 18a, at 200°C for 10 minutes in Example 18b, and at

220°C for 10 minutes in Example 18c to produce 30-µm-thick bonding sheets, respectively.

(Examples 19a, 19b, and 19c)

In Examples 19a, 19b, and 19c, bonding sheets were produced in the same manner as described in Examples 18a, 18b, and 18c, with an exception that the composition solution obtained in Example 19 was used.

(Examples 20a , 20b, and 20c)(Comparative examples 15a, 15b, 15c, 16a, 16b, and 16c)

In Examples 20a, 20b, and 20c and Comparative examples 15a, 15b, 15c, 16a, 16b, and 16c, bonding sheets were produced in the same manner and conditions as described above. Since ingredients were not completely dissolved in Comparative examples 18, 19, and 20, bonding sheets were not produced using the composition solutions obtained in those examples.

(Evaluation of properties of film-like laminate member)

1. (Amount of residual solvent)

The amount of residual solvent was determined as follows:

(1)A sample film was thermally decomposed and vaporized in the thermal cracking plant.
(2)The gas generated by thermal decomposition was fed to a column of a GC-MS, and then the measurement was started.
(3)A peak area of the measurement value was compared to that of a calibration curve to determine the weight of the solvent.
(4)The amount of residual solvent was calculated from the weight ratio between the discomposed sample film and the solvent.

In that case, the calibration curve was prepared as follows:

(1)A target solvent was injected into the GC-MS to determine a peak area.
(2)In the same manner, various amount of solvents were injected into the column to determine the respective peak areas.
(3)The obtained results were plotted on the graph (x-axis: amount of solvent, y-axis: peak area)
(4)Based on the graph, the calibration curve was prepared.

The solvent content in the film was determined by comparing the above-prepared calibration curve to the peak area of the thermally decomposed film.
The devices and conditions used in the above determination were as follows.
Thermal cracking plant: JHP-3 (Japan Analytical Industry Co.,Ltd)
GC: Hp5890-II (Hewlett-Packard Company)
MS: Hp5871A (Hewlett-Packard Company)

- Decomposing condition: 358°C×5 sec.
- Column: DB-5 capillary column
- Temperature profile: 35°C (5 minutes) → temperature rise(10°C/min.) → 150°C(1.5 minutes)
- Inlet/detector: 250°C/280°C
- Oven/needle temperature: 200°C/200°C
- Split ratio: 1/30
- Sample amount: 0.5 mg

2.(Peeling strength)

Peeling strength of a flexible copper clad laminate was measured as follows.
A film-like laminate member and an 18-µm-thick electrolytic copper foil are thermally pressed at 200°C and a pressure of 3MPa for 20 minutes to produce a flexible copper clad laminate. The peeling strength of the laminate was measured in accordance with Japanese Industrial Standard JIS C6481. In that case, the conductor width was 3 mm.
Table 2 shows the evaluation results of the properties of the film-like laminate member obtained in Examples

and Comparative examples.

TABLE 2

| | THF | dioxane | dioxolane | DMF | NMP | DMAc |
|---|---|---|---|---|---|---|
| Amount of residual solvent(%) | Example 18a | Example 19a | Example 20a | Comparative example 15a | Comparative example 16a | Comparative example 17a |
| | 0.5 | 3.2 | 0.8 | 5.1 | 8.0 | 6.2 |
| | Example 18b | Example 19b | Example 20b | Comparative example 15b | Comparative example 16b | Comparative example 17b |
| | 0.0 | 1.3 | 0.2 | 2.0 | 4.3 | 3.5 |
| | Example 18c | Example 19c | Example 20c | Comparative example 15c | Comparative example 16c | Comparative example 17c |
| | 0.0 | 0.2 | 0.1 | 0.9 | 1.9 | 1.4 |
| Peeling strength (kgf/cm) | Example 18a | Example 19a | Example 20a | Comparative example 15a | Comparative example 16a | Comparative example 17a |
| | 1.00 | 0.97 | 1.00 | 1.00 | 0.98 | 1.00 |
| | Example 18b | Example 19b | Example 20b | Comparative example 15b | Comparative example 16b | Conparative example 17b |
| | 0.72 | 0.66 | 0.70 | 0.67 | 0.51 | 0.53 |
| | Example 18c | Example 19c | Example 20c | Comparative example 15c | Comparative example 16c | Comparative example 17c |
| | 0.12 | 0.11 | 0.11 | 0.13 | 0.06 | 0.10 |

(Examples 21 to 39 and Comparative examples 21 to 24)

As shown in Tables 3 and 4, the polyimides produced in Examples 1 to 9 and Comparative examples 1 and 2, epoxy resins, and an accelerator or a curing agent were mixed with the listed solvents to prepare adhesive agent solutions.

Then, each adhesive agent solution was applied to 100-μm-thick polyethylene terephthalate film so that the thickness of each adhesive agent was in a range of 25 to 50 μm after drying. Then, it was dried at 40°C for 2 minutes, peeled from the film, fixed to a frame with pins, dried at 120°C for 5 minutes and at 170°C for 3 minutes to remove solvents, and thermally pressed on a release film (PET or PEN) having a thickness of 25 to 50 μm at 140°C and a pressure of 1MPa for 3 minutes. Thus, a bonding sheet was produced.

Next, in order to evaluate the properties of this bonding sheet, the release film was removed from the bonding sheet to obtain an adhesive sheet. Then, the adhesive sheet was laminated to a roughened surface of an 18-μm-electrolytic copper foil at 200°C and a pressure of 3MPa for 5 minutes, and cured at 170°C for 3 hours to prepare a laminated film with adhesive agent.

The properties of thus-obtained laminated film are shown in Table 3. Compared to the evaluation results of Comparative examples shown in Table 4, it is clear that the bonding sheet of the present invention has more excellent adhesion and solder heat resistance.

TABLE 3

| | | Example 21 | Example 22 | Example 23 | Example 24 | Example 25 | Example 26 | Example 27 | Example 28 | Example 29 | Example 30 |
|---|---|---|---|---|---|---|---|---|---|---|---|
| Polyimide | Type | Polyimide of Example 1 | Polyimide of Example 2 | Polyimide of Example 1 | Polyimide of Example 1 | Polyimide of Example 3 | Polyimide of Example 4 | Polyimide of Example 1 | Polyimide of Example 1 | Polyimide of Example 1 | Polyimide of Example 1 |
| | Number of parts by weight | 90 | 95 | 85 | 90 | 90 | 95 | 90 | 85 | 90 | 90 |
| Epoxy resin | Type | 180H65 | 1001 | YX4000H | ESN-375 | ESN-185 | EPPN-502H | 1032H60 | 1032H60 | 1032H60 | 1032H60 |
| | Number of parts by weight | 10 | 5 | 15 | 10 | 10 | 5 | 10 | 5 | 5 | 5 |
| Epoxy resin | Type | - | - | - | - | - | - | - | YX4000H | ESN-375 | 1001 |
| | Number of parts by weight | - | - | - | - | - | - | - | 10 | 5 | 5 |
| Accelerator | Type | - | Phthalic anhydride | Triethylene tetramine | Phthalic anhydride | - | Phthalic anhydride | - | - | - | - |
| | Number of parts by weight | - | 3 | 5 | 5 | - | 5 | - | - | - | - |
| Curing agent | Type | 4,4'-DDS | 3,3'-DDS | 4,4'-DDS | 3,3'-DDS | 3,3'-DDS | 3,3'-DDS | 4,4'-DDS | 4,4'-DDS | 4,4'-DDS | 4,4'-DDS |
| | Number of parts by weight | 3 | 10 | 5 | 6 | 5 | 10 | 3 | 3 | 5 | 5 |
| Solvent for preparing adhesive agent | | THF | 1,3-dioxolane | tetrahydrofuran | 1,3-dioxolane | 1,3-dioxolane | 1,3-dioxolane | tetrahydrofuran | 1,3-dioxolane | 1,3-dioxolane | tetrahydrofuran |
| Thickness of adhesive agent | [μm] | 35 | 25 | 35 | 35 | 50 | 35 | 35 | 35 | 35 | 35 |
| Release film | Type | PET | PEN | PET | PET | PET | PEN | PET | PET | PET | PET |
| | Thickness [μm] | 50 | 50 | 25 | 25 | 50 | 25 | 25 | 25 | 25 | 25 |
| Adhesive strength | [kg/cm] | 1.7 | 1.6 | 1.7 | 1.6 | 1.6 | 1.7 | 1.7 | 1.7 | 1.7 | 1.7 |
| Solder heat resistance | Good; no swelling | Good | Good | Good | Good | Good | Good | Good | Good | Good | Good |

TABLE 3 (continued)

| | | Example 31 | Example 32 | Example 33 | Example 34 | Example 35 | Example 36 | Example 37 | Example 38 | Example 39 |
|---|---|---|---|---|---|---|---|---|---|---|
| Polyimide | Type | Polyimide of Example 5 | Polyimide of Example 6 | Polyimide of Example 7 | Polyimide of Example 7 | Polyimide of Example 7 | Polyimide of Example 7 | Polyimide of Example 7 | Polyimide of Example 8 | Polyimide of Example 9 |
| | Number of parts by weight | 90 | 95 | 85 | 90 | 90 | 90 | 90 | 85 | 85 |
| Epoxy resin | Type | 180H65 | 1001 | 1032H60 | 1032H60 | 1032H60 | YX4000H | 1032H60 | 1032H60 | 1032H60 |
| | Number of parts by weight | 10 | 5 | 5 | 5 | 5 | 10 | 10 | 5 | 5 |
| Epoxy resin | Type | - | - | YX4000H | ESN-375 | 1001 | - | - | YX4000H | ESN-375 |
| | Number of parts by weight | - | - | 10 | 5 | 5 | - | - | 10 | 10 |
| Accelerator | Type | - | Phthalic anhydride | - | - | - | Triethylene tetramine | - | - | - |
| | Number of parts by weight | - | 3 | - | - | - | 3 | - | - | - |
| Curing agent | Type | 4,4'-DDS | 4,4'-DDS | 4,4'-DDS | 4,4'-DDS | 4,4'-DDS | 4,4'-DDS | 4,4'-DDS | 3,3'-DDS | 3,3'-DDS |
| | Number of parts by weight | 3 | 10 | 3 | 5 | 5 | 5 | 3 | 3 | 5 |
| Solvent for preparing adhesive agent | | 1,4-dioxolane | 1,3-dioxolane | N,N-dimethyl formamide | tetrahydro furan | tetrahydro furan | 1,3-dioxolane | tetrahydro furan | 1,3-dioxolane | 1,3-dioxolane |
| Thickness of adhesive agent | [μm] | 35 | 25 | 35 | 35 | 50 | 35 | 35 | 35 | 35 |
| Release film | Type | PET | PEN | PET | PET | PET | PEN | PET | PET | PET |
| | Thickness [μm] | 50 | 50 | 25 | 25 | 50 | 25 | 25 | 25 | 25 |
| Adhesive strength | [kg/cm] | 1.7 | 1.6 | 1.7 | 1.6 | 1.7 | 1.7 | 1.7 | 1.7 | 1.7 |
| Solder heat resistance | Good: no swelling | Good | Good | Good | Good | Good | Good | Good | Good | Good |

Table 4

| | | Comparative example 21 | Comparative example 22 | Comparative example 23 | Comparative example 24 |
|---|---|---|---|---|---|
| Polyimide | Type | Polyimide of Example 1 | Polyimide of Example 2 | Polyimide of Comparative example 1 | Polyimide of Comparative example 2 |
| | Amount of parts by weight | 90 | 95 | 85 | 90 |
| Epoxy resin | Type | 180H65 | - | YX4000H | ESN-375 |
| | Amount of parts by weight | 10 | - | 15 | 10 |
| Epoxy resin | Type | - | - | - | - |
| | Amount of parts by weight | - | - | - | - |
| Accelerator | Type | - | Phthalic anhydride | Triethylene Tetramine | Phthalic anhydride |
| | Amount of parts by weight | - | 3 | 5 | 5 |
| Curing agent | Type | - | 3,3'-DDS | 4,4'-DDS | 3,3'-DDS |
| | Amount of parts by weight | - | 10 | 5 | 6 |
| Solvent for preparing adhesive agent | | THF | 1,3-dioxolane | N,N-dimethyl acetamide | N-methyl pyrrolidone |
| Thickness of adhesive agent | [μm] | 35 | 25 | 35 | 35 |
| Release film | Type | PET | PEN | PET | PET |
| | Thickness [μm] | 50 | 50 | 25 | 25 |
| Adhesive strength | [kg/cm] | 0.1 | 0 | 0.3 | 0.3 |
| Solder heat resistance | Good: no swelling Bad | Bad | Bad | Bad | Bad |

In the following Examples 40 to 44 and Comparative examples 25 and 26, adhesive laminated films for covering an accelerator beam tube and for covering a conductor wire for an accelerator quench heater were produced and the properties of the respective films were evaluated.

(Example 40)

20 g of polyimide powders obtained in Example 1, 5 g of Epikote 1032H60 (Yuka Shell Epoxy Co.,Ltd.), and 3 g of 4,4-diaminodiphenylsulfone were dissolved in 83 g of DMF to produce a varnish. The varnish was cast over a PET film, dried at 100°C for 10 minutes, peeled from the PET film, fixed to an iron frame, and then dried at 150°C for 20 minutes to produce a 5-μm-thick film of thermoplastic polyimide and thermosetting resin which is to be used as an adhesive layer in the present invention.

Thus-obtained film was laminated to both sides of a 50-μm-thick polyimide film APICAL 50 AH (Kaneka Corporation) at 150°C and a pressure of 2.2 cm/min. to produce 60-μm-thick adhesive laminated film for covering an accelerator beam tube or for covering a conductor wire for an accelerator quench heater.

A glass transition temperature of the thermoplastic polyimide was measured by TMA. The measurement value was 190°C. Further, its water absorption was measured in accordance with ASTM D-570 by immersing it in pure water

at 20°C for 24 hours. The measurement value was 0.9%.

Furthermore, the release paper was peeled off the laminated film, and then a copper foil is laminated thereto at 180°C and a pressure of 30 kg/$cm^2$ for 10 minutes. Its peeling strength was measured in accordance with JIS K6481 (at room temperature) so as to use it as the reference when the peeling strength between the adhesive laminated film for covering an accelerator beam tube and the accelerator beam tube or between the adhesive laminated film for covering a conductor wire for an accelerator quench heater and the accelerator quench heater was measured. The measurement value was 1.1 kg/cm. The adhesive laminated film for covering an accelerator beam tube or for covering a conductor wire for an accelerator quench heater was subjected to a radiation resistance test by applying radiation 5MGy using 2MeV electron beam. No change was found in color and performance. Results of measurements are shown in Table 5.

TABLE 5

| | Glass transition temperature (°C) | Water absorption (%) | Peeling strength (kg/cm) | Radiation resistance test |
|---|---|---|---|---|
| Example 40 | 190 | 0.9 | 1.1 | No change |
| Example 41 | 190 | 0.9 | 1.2 | No change |
| Example 42 | 190 | 0.9 | 1.1 | No change |
| Example 43 | 220 | 0.9 | 1.1 | No change |
| Example 44 | 160 | 0.9 | 1.2 | No change |
| Comparative example 25 | - | 2.6 | Not bonded | No change |
| Comparative example 26 | 178 | 2.0 | 0.3 | Turned black |

(Example 41)

20 g of polyimide powders obtained in Example 1, 5 g of Epikote 1032H60 (Yuka Shell Epoxy Co.,Ltd.), and 3 g of 4,4'-diaminodiphenylsulfone were dissolved in 83 g of DMF to produce a varnish. The varnish was directly applied to one surface of the polyimide film so that a 10-µm-thick adhesive laminated film was produced after drying.

A release paper was peeled off the laminated film, and then a copper foil is laminated thereto at 180°C and a pressure of 3MPa for 10 minutes. Its peeling strength was measured in accordance with JIS K6481 (at room temperature) so as to use it as the reference when the peeling strength between the adhesive laminated film for covering an accelerator beam tube and the accelerator beam tube or between the adhesive laminated film for covering a conductor wire for an accelerator quench heater and the accelerator quench heater was measured. The measurement value was 1.2 kg/cm. The adhesive laminated film for covering accelerator beam tube and the adhesive laminated film for covering conductor wire for accelerator quench heater were subjected to a radiation resistance test by applying radiation 5MGy using 2MeV electron beam. No change was found in color and performance. Results of measurements are shown in Table 5.

(Example 42)

An adhesive sheet was produced in the same manner as Example 40, with an exception that the polyimide obtained in Example 6 was used.

Thus-obtained film was laminated on both sides of a polyimide film APICAL 50 AH (Kaneka Corporation) at 150°C and a pressure of 2.2 cm/min. to produce a 60-µm-thick adhesive laminated film for covering an accelerator beam tube or for covering a conductor wire for an accelerator quench heater.

A glass transition temperature of the thermoplastic polyimide was measured by TMA. The measurement value was 190°C. Further, its water absorption was measured in accordance with ASTM D-570 by soaking it in pure water at 20°C for 24 hours. The measurement value was 0.9%.

A release paper was peeled off the laminated film, and then a copper foil is laminated thereto at 180°C and a pressure of 3MPa for 10 minutes. Its peeling strength was measured in accordance with JIS K6481 (at room temperature) so as to use it as the reference when peeling strength between the adhesive laminated film for covering an accelerator beam tube and the accelerator beam tube or between the adhesive laminated film for covering a conductor wire for an accelerator quench heater and the accelerator quench heater was measured. The measurement value was

1.1 kg/cm. The adhesive laminated film for covering an accelerator beam tube or for covering a conductor wire for an accelerator quench heater was subjected to a radiation resistance test by applying radiation 5MGy using 2MeV electron beam. No change was found in color and performance. Results of measurements are shown in Table 5.

(Example 43)

An adhesive sheet was produced in the same manner as Example 40, with an exception that the polyimide obtained in Example 3 was used.

Thus-obtained film was laminated on both sides of a polyimide film APICAL 50 AH (Kaneka Corporation) at 150°C and a pressure of 2.2 cm/min. to produce an adhesive laminated film for covering an accelerator beam tube or for covering a conductor wire for an accelerator quench heater.

A glass transition temperature of the thermoplastic polyimide was measured by TMA. The measurement value was 220°C. Further, its water absorption was measured in accordance with ASTM D-570 by soaking it in pure water at 20°C for 24 hours. The measurement value was 0.9%.

A release paper was peeled off the laminated film, and then a copper foil is laminated thereto at 180°C and a pressure of 3MPa for 10 minutes. Its peeling strength was measured in accordance with JIS K6481 (at room temperature) so as to use it as the reference when peeling strength between the adhesive laminated film for covering an accelerator beam tube and the accelerator beam tube or between the adhesive laminated film for covering a conductor wire for an accelerator quench heater and the accelerator quench heater was measured. The measurement value was 1.1 kg/cm. The adhesive laminated film for covering an accelerator beam tube or for covering a conductor wire for an accelerator quench heater was subjected to a radiation resistance test by applying radiation 5MGy using 2MeV electron beam. No change was found in color and performance. Results of measurements are shown in Table 5.

(Example 44)

An adhesive sheet was produced in the same manner as Example 40, with an exception that the polyimide obtained in Example 7 was used.

Thus-obtained film was laminated on both sides of a polyimide film APICAL 50 AH (Kaneka Corporation) at 150°C and a pressure of 2.2 cm/min. to produce an adhesive laminated film for covering an accelerator beam tube or for covering a conductor wire for an accelerator quench heater.

A glass transition temperature of the thermoplastic polyimide was measured by TMA. The measurement value was 160°C. Further, its water absorption was measured in accordance with ASTM D-570 by soaking it in pure water at 20°C for 24 hours. The measurement value was 0.9%.

A release paper was peeled off the laminated film, and then a copper foil is laminated thereto at 180°C and a pressure of 3MPa for 10 minutes. Its peeling strength was measured in accordance with JIS K6481 (at room temperature) so as to use it as the reference when peeling strength between the adhesive laminated film for covering an accelerator beam tube and the accelerator beam tube or between the adhesive laminated film for covering a conductor wire for an accelerator quench heater and the accelerator quench heater was measured. The measurement value was 1.2 kg/cm. The adhesive laminated film for covering an accelerator beam tube or for covering a conductor wire for an accelerator quench heater was subjected to a radiation resistance test by applying radiation 5MGy using 2MeV electron beam. No change was found in color and performance. Results of measurements are shown in Table 5.

(Comparative example 25)

In substantially the same manner as described in the Examples, polyamide acid was produced from pyromelletic dianhydride and ODA (oxydianiline). The polyamide acid was cast over a polyimide film (APICAL (trademark) available from Kaneka Corporation), dried at 80°C for 25 minutes, at 150°C for 5 minutes, at 250°C for 5 minutes, at 270°C for 5 minutes, and 300°C for 5 minutes for imidization. Thus an adhesive laminated film was produced.

The respective properties of thus-obtained film was measured in the same manner as described in Examples. A polyimide resin layer of the film had no glass transition temperature, and water absorption of the film was 2.6%. The peel strength of the adhesive laminated film was tried to be measured. However, it could not be laminated to a copper foil at a temperature of 180°C at a pressure of 30 kg/cm$^2$ for 10 minutes, and therefore it could not be measured. Under a radiation resistance test, no change was found in color and performance. Results of the measurements are shown in Table 5.

(Comparative example 26)

An adhesive laminated film for covering an accelerator beam tube or for covering a conductor wire for an

accelerator quench heater was produced in the same manner as described in Example 2, with an exception that an adhesive agent Epikote 828 (Yuka Shell Epoxy Kabushiki Kaisha) was used instead of the thermoplastic polyimide film. The respective properties of the film were measured in the same manner as described in Example 1. An adhesive layer of the film had a glass transition temperature of 178°C and water absorption of 2.0%. Peeling strength of the adhesive laminated film was 0.3 kg/cm. The film was blackened under the radiation resistance test. Results of the measurements are shown in Table 5.

ADVANTAGES OF THE INVENTION

The soluble polyimide of the present invention has a solubility of 10 % or higher in a low-boiling solvent such as 1,4 dioxane and THF, and may have a glass transition temperature of 100°C or higher and water absorption of 2.0% or less. Accordingly, the polyimide of the present invention has an excellent workability as a coating film and adhesive agent. Specifically, the soluble polyimide according to the present invention is mixed with epoxy resin and is used as polyimide composition, polyimide adhesive solution, laminate member, bonding sheet, and adhesive laminated film for covering an accelerator beam tube or for covering a conductor wire for an accelerator quench heater.

The composition can be bonded at a relatively low temperature, for example, at about 250°C, when it is used as an adhesive agent. Unlike a conventional heat-resistant adhesive agent, it can be bonded at a low temperature, has high adhesion to polyimide, and retain high adhesive strength even at a high temperature. Further, the composition has low water absorption of 1.5% or less. Furthermore, by adjusting a residual volatile content to 3 wt% or less, peeling strength of the composition can be retained even after a PCT treatment. The composition has enough solder heat resistance, and therefore it does not swell when it is dipped in a solder bath.

Using the adhesive solution of the present invention, almost all the high-boiling solvents can be removed from a base film when the film is dried after an adhesive solution is applied to the film. In the case of a conventional adhesive solution, it contains only high boiling solvents such as DMF and NMP. For this reason, it must be dried at a high temperature to remove the solvents from the film, and its adhesive strength is significantly reduced. In order to provide high adhesive properties to the solution, there is no other choice but to allow some residual solvents to be left in the solution. On the contrary, in the case of the adhesive solution of the present invention, solvents can be easily removed from a film and high adhesive properties can be achieved even under such drying conditions that residual solvents are significantly reduced. The thermoplastic polyimide to be used in the adhesive solution of the present invention has relatively lower glass transition temperature than a conventional thermoplastic polyimide, so that it can be bonded at lower temperature. Further, the adhesive solution and film-like laminated member using the adhesive solution exhibit excellent heat resistance, workability, and adhesive properties, and solvents can be easily removed therefrom.

The bonding sheet of the present invention is made of a soluble polyimide which has a solubility of 10 % or higher in a low-boiling solvent such as 1,4-dioxane, 1,3-dioxalane, and THF, so that it is excellent in workability as a coating film and adhesive agent. Since the bonding sheet of the present invention is made of the soluble polyimide having a high glass transition temperature and low water absorption, it is applicable to an adhesive agent, composite material, or electric and electronic materials. Specifically, the bonding sheet of the present invention can be used in the fields where heat resistance and adhesive properties are required as a printed wiring board, flexible wiring board, TAB (Tape Automated bonding) tape, composite lead frame, tape carrier, adhesive agent for an electronic component such as a semiconductor integrated circuit device, adhesive film, and adhesive agent or bonding agent for bonding an aluminum, iron, ceramics, fiber, and filler.

The adhesive laminated film for covering an accelerator beam tube according to the present invention is composed of polyimide (as a base film) having an excellent heat resistance, radiation resistance, electrical characteristics, chemical resistance, and low-temperature characteristics and an adhesive layer which is made of thermoplastic resin having a glass transition temperature of 100°C to 250°C and water absorption of 1.5% or less and thermosetting resin having an excellent adhesive properties at a relatively low temperature. Therefore, it has an excellent workability, flexibility, and adhesive properties at a low temperature, and suffers very little degradation of performance due to water absorption. When an accelerator beam tube is coated with this film, the tube is protected from radiation by the film. Since the film has thus comprehensively excellent properties, it is suitably used for coating a superconducting accelerator beam tube or for coating a superconducting magnet for an accelerator. Likewise, when a conductor wire for accelerator quench heater is coated with this film, the conductor wire is protected from radiation by the film. Since the film has comprehensively excellent properties, it is suitably used for coating a conductor wire for a superconducting accelerator quench heater or for coating a superconducting magnet for an accelerator.

## Claims

**1.** A soluble polyimide having a solubility of 10 % or higher at 20°C in an organic solvent of N, N-dimethylformamide,

1,4-dioxane, 1,3-dioxolane, or tetrahydrofuran.

2. A soluble polyimide having a solubility of 10 % or higher at 20°C in an organic solvent of N, N-dimethylformarnide, 1,4-dioxane, 1,3-dioxolane, or tetrahydrofuran; a glass transition temperature of 100°C to 250°C; and water absorption of 1.5 % or less.

3. The soluble polyimide according to claim 1 or 2, which is obtained by reacting ester acid dianhydride represented by the general formula (1)

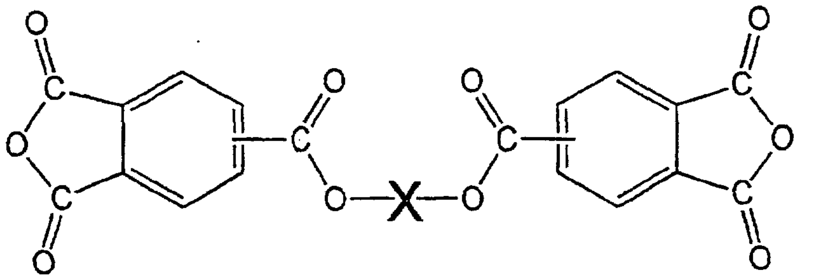
(1)

(wherein X represents a bivalent organic group including $-(CH_2)_k-$ or an aromatic group and k is an integer of 1 to 10) with a diamine or diisocyanate compound represented by the general formula (2)

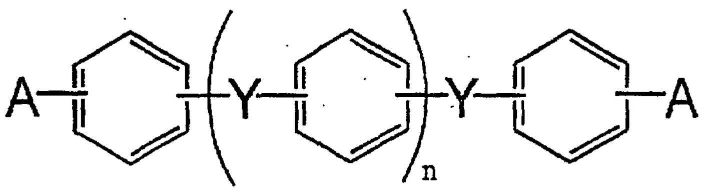
(2)

(wherein A represents $-NH_2-$ or -NCO; Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond; and m and n each are an integer of 0 to 10).

4. The soluble polyimide according to claim 3, wherein the acid dianhydride represented by the general formula (1) is 2,2-bis(4-hydroxyphenyl)propane dibenzoate-3,3',4,4'-tetracarboxylic dianhydride

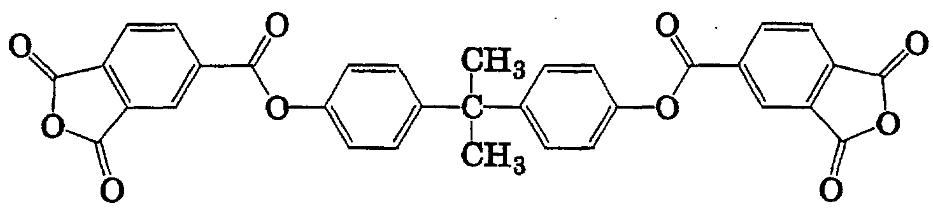

5. The soluble polyimide according to claim 3, which is obtained by reacting an acid dianhydride component containing 50 mol% of 2,2-bis(4-hydroxyphenyl)propane dibenzoate-3,3',4,4'- tetracarboxylic dianhydride

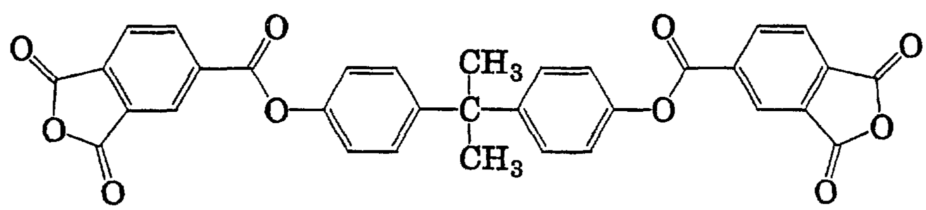

with the diamine or diisocyanate component represented by the general formula (2).

**6.** The soluble polyimide according to claim 3, wherein the general formula (2) is represented by

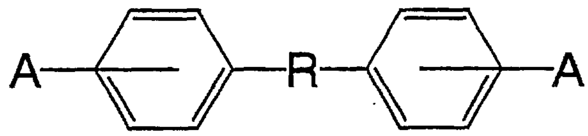

(wherein A represents $-NH_2$ or -NCO and R represents a bivalent organic group selected from the group consisting of $-CH_2-$ and

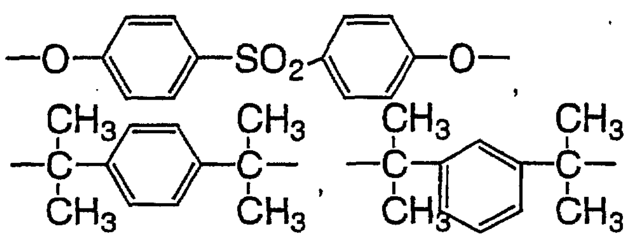

).

**7.** The soluble polyimide according to claim 3, wherein the diamine or diisocyanate compound represented by the above general formula is 1,3-bis(aminophenoxy)benzene

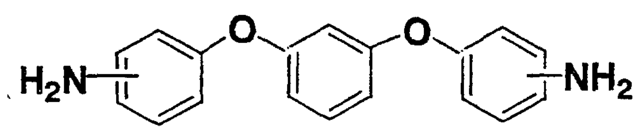

or 1,3-bis(isocyanatephenoxy)benzene

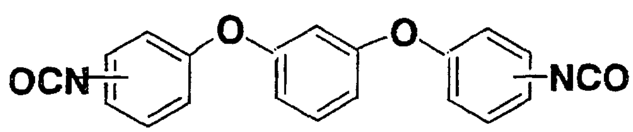

**8.** The soluble polyimide according to claim 3, wherein the diamine or diisocyanate compound represented by the general formula (2) is represented by the following general formula (4)

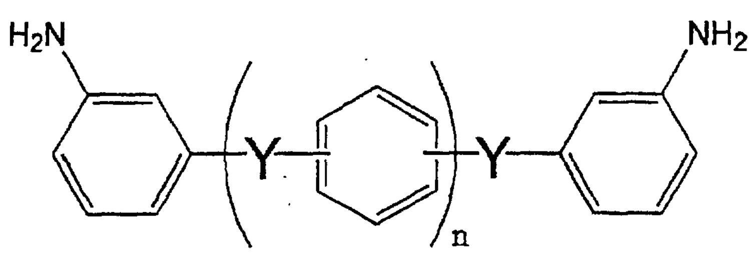

(4)

(wherein Y independently represents -C(=O)-, $-SO_2-$, -O-, -S-, $-(CH_2)_m-$, -NHCO-, $-C(CH_3)_2-$, $-C(CF_3)_2-$, -C(=O)O-, or a single bond, and m and n each are an integer of 1 to 10).

**9.** A soluble polyimide obtained by reacting an acid dianhydride component including ester acid dianhydride represented by the general formula (1)

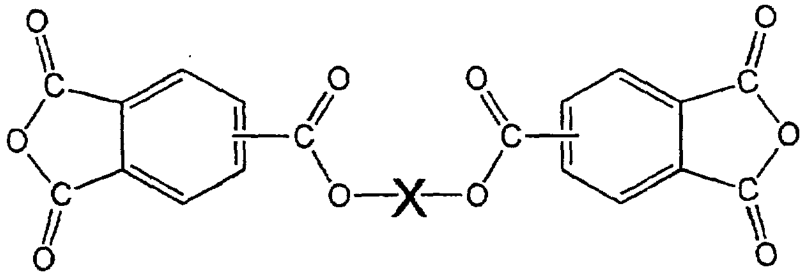

(1)

(wherein X represents a bivalent organic group having $-(CH_2)_k-$ or an aromatic group and k is an integer of 1 to 10) with a diamine component including the diamine represented by the general formula (2)

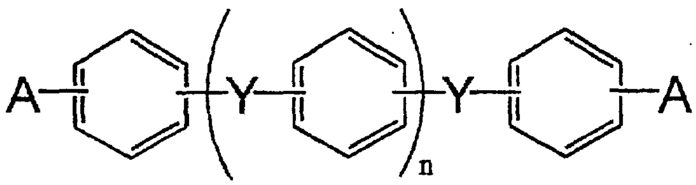

(2)

(wherein A represents $-NH_2-$ or -NCO; Y independently represents -C(=O)-, $-SO_2-$, -O- , -S-, $-(CH_2)_m-$, -NHCO-, $-C(CH_3)_2-$, $-C(CF_3)_2-$, -C(=O)O- or a single bond; and m and n each are an integer of 0 to 10) in an organic solvent to prepare an organic solvent solution of polyamide acid; and by heating said organic solvent solution under a reduced pressure to imidize the polyamide acid.

**10.** The soluble polyimide according to claim 9, wherein said organic solvent solution is heated under a reduced pressure at a temperature of 80°C to 400°C and/or a pressure of $0.001\times10^5$ to $0.9\times10^5$ Pa.

**11.** A resinous composition for an adhesive agent, comprising:

polyimide resin; and
epoxy resin,

wherein said polyimide resin is obtained by reacting an acid dianhydride component containing ester acid dianhydride represented by the general formula (1)

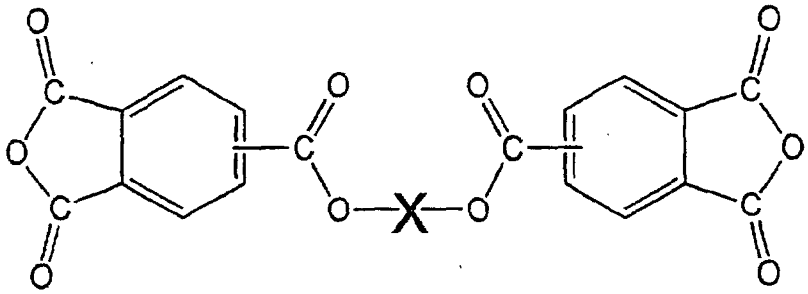

(1)

(wherein X represents a bivalent organic group including $-(CH_2)_k-$ or an aromatic group and k is an integer of 1 to 10) with a diamine component containing diamine represented by the general formula (2)

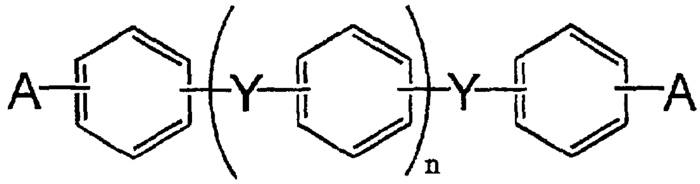

(2)

(wherein A represents $-NH_2-$ or -NCO, Y is -C(=O)-, $-SO_2-$, -O-, -S-, $-(CH_2)_m-$, -NHCO-, $-C(CH_3)_2-$, $-C(CF_3)_2-$, -C(=O)O-, or a single bond, and m and n each are an integer of 0 to 10).

**12.** A resinous composition for an adhesive agent, **characterized by** comprising polyimide resin and epoxy resin, wherein said polyimide resin is obtained by reacting ester acid dianhydride represented by the general formula (1)

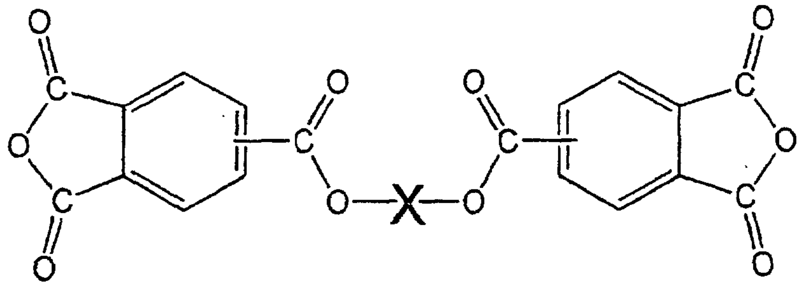

. . (1)

(wherein X represents a bivalent organic group including $-(CH_2)_k-$ or an aromatic group and k is an integer of 1 to 10) with a diamine component; said diamine component contains diamine represented by the general formula (2)

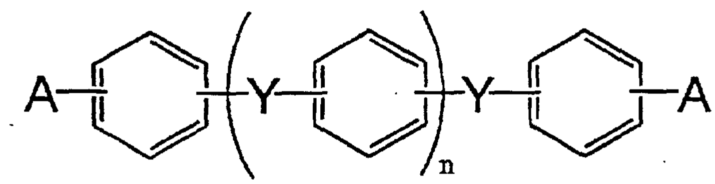

(2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O-, or a single bond, and m and n each are an integer of 0 to 10) and 3,3'-dihydroxy-4,4'-diaminobiphenyl represented by the general formula (3)

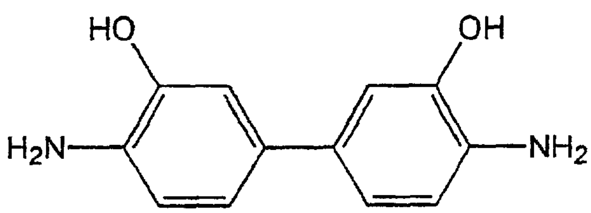

(3)

;

said diamine makes up 0 to 99 mol% of the whole diamine component and said 3,3-dihydroxy-4,4'-diaminobiphenyl makes up 1 to 100 mol% of the whole diamine component.

**13.** The composition according to claim 11 or 12, futher comprising at least one kind of low-boiling solvents.

**14.** The composition according to claim 11 or 12, which is obtained by dissolving thermoplastic polyimide, epoxy resin, and curing agent in an organic solvent containing a cyclic ether solvent.

**15.** The composition according to claim 14, wherein said organic solvent contains 30 wt% or more of cyclic ether solvent.

**16.** A bonding sheet comprising at least an adhesive layer, wherein said adhesive layer is made of a resinous composition containing a polyimide resin and an epoxy rein and said polyimide resin is a soluble polyimide resin having a solubility of 10% or higher at 20°C in an organic solvent of N, N-dimethylformamide, 1,4-dioxane, 1,3-dioxolane, or tetrahydrofuran.

**17.** The bonding sheet according to claim 16, wherein, when said adhesive layer is cured, a residual volatile left in the cured layer is 3 wt% or less of the total weight of the cured layer and/or the cured layer has water absorption of 1.5 % or less.

**18.** The bonding sheet according to claim 17, wherein said soluble polyimide resin is obtained by reacting ester acid dianhydride represented by the general formula (1)

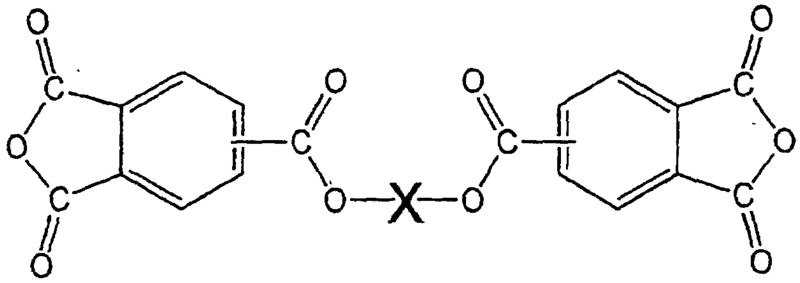

(1)

(wherein X represents a bivalent organic group having $-(CH_2)_k-$ or an aromatic group and k is an integer of 1 to 10) with a diamine or diisocyanate component represented by the general formula (2)

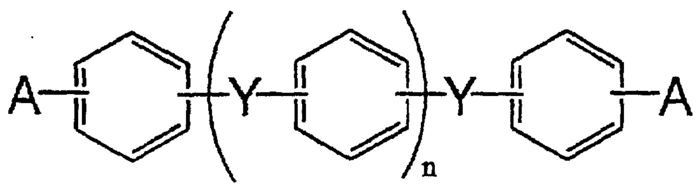

(2)

(wherein A represents $-NH_2-$ or -NCO, Y independently represents -C(=O)-, $-SO_2-$, -O-, -S-, $-(CH_2)_m-$, -NHCO-, $-C(CH_2)_m-$, $-C(CF_3)_2-$, -C(=O)O-, or a single bond, and m and n each are an integer of 0 to 10).

**19.** The bonding sheet according to claim 18, **characterized in that** said soluble polyimide resin is obtained by reacting an acid dianhydride component including 2,2-bis(4-hydroxyphenyl)propane dibenzoate-3,3',4,4'-tetracarboxylic dianhydride represented by the general formula (2)

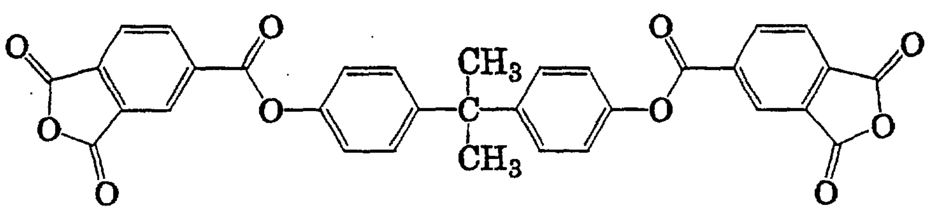

with a diamine or diisocyanate component.

**20.** The bonding sheet according to claim 18, **characterized in that** said soluble polyimide resin is obtained by reacting a diamine or diisocyanate component including 1,3-bis(aminophenoxy)benzene;

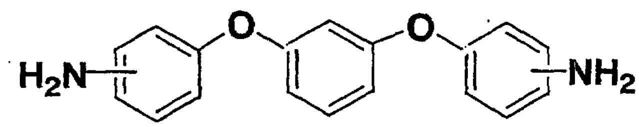

or 1,3-bis(isocyanatephenoxy)benzene;

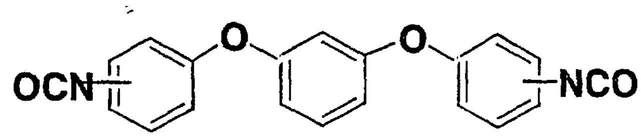

with the acid dianhydride component.

**21.** A bonding sheet obtained by casting or applying the composition according to any one of claims 11 to 15 over a support, drying the composition, and subsequently peeling an adhesive layer from the support.

**22.** A bonding sheet comprising a polyimide adhesive layer on a surface thereof, wherein said polyimide adhesive layer is obtained by casting or applying the composition according to any one of claims 11 to 15 over at least one surface of a polyimide film and subsequently drying the composition.

**23.** The bonding sheet according to claim 21 or 22, wherein a thickness of said polyimide adhesive layer is 5 to 30 μm.

**24.** The bonding sheet according to any one of claims 16 to 20, comprising at least an adhesive layer, wherein main constituents of said adhesive layer are:

I) 100 parts by weight of soluble polyimide resin;
II) 3 to 100 parts by weight of epoxy resin; and
III) 0.5 to 50 parts by weight of accelerator or curing agent.

**25.** The bonding sheet according to claim 21 or 22, comprising a mold release film on at least one surface thereof.

**26.** The bonding sheet according to claim 25, wherein said mold release film is mainly composed of PET(polyethylene terephthalate) or PEN (polyethylene naphthalate).

**27.** An adhesive laminated film for covering an accelerator beam tube, comprising an adhesive layer on at least one surface of a polyimide film, wherein said adhesive layer is composed of a composition containing a thermoplastic resin having a glass transition temperature of 100°C to 250°C and water absorption of 1.5 % or less and a thermosetting resin.

**28.** The adhesive laminated film for covering an accelerator beam tube according to claim 27, wherein said thermoplastic resin is a soluble polyimide resin obtained by reacting an acid dianhydride component including ester acid dianhydride represented by the general formula (1)

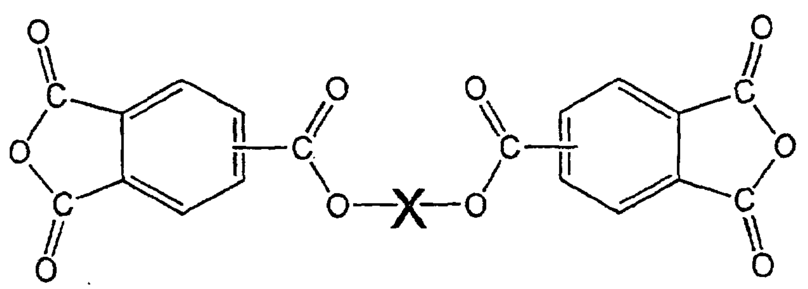

(1)

(wherein X represents a bivalent organic group having $-(CH_2)_k-$ or an aromatic group and k is an integer of 1 to

10) with a diamine component represented by the general formula (2)

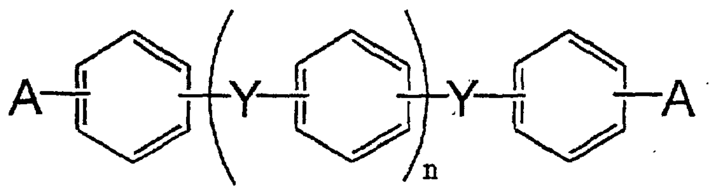 (2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10).

**29.** The adhesive laminated film for covering an accelerator beam tube according to claim 27 or 28, wherein said thermosetting resin comprises two or more kinds of epoxy groups in one molecule.

**30.** An adhesive laminated film for covering a conductor wire for an accelerator quench heater, comprising an adhesive layer on at least one surface of a polyimide film, wherein said adhesive layer is composed of a composition containing a soluble polyimide resin having a glass transition temperature of 100°C to 250°C and water absorption of 1.5 % or less and a thermosetting resin.

**31.** The adhesive laminated film for covering a conductor wire for an accelerator quench heater according to claim 30, wherein said soluble polyimide is a polyimide resin obtained by reacting an acid dianhydride component including ester acid dianhydride represented by the general formula (1)

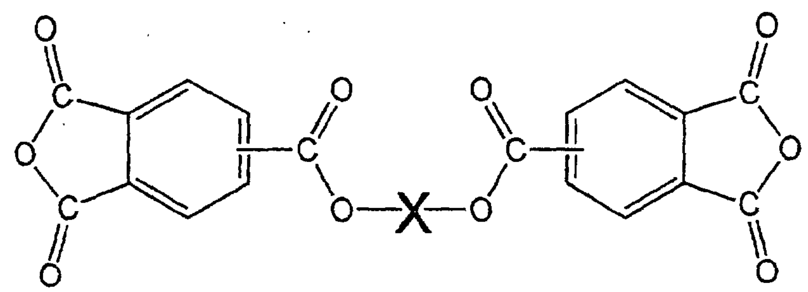 (1)

(wherein X represents a bivalent organic group having $-(CH_2)_k-$ or an aromatic group and k is an integer of 1 to 10) with a diamine component represented by the general formula (2)

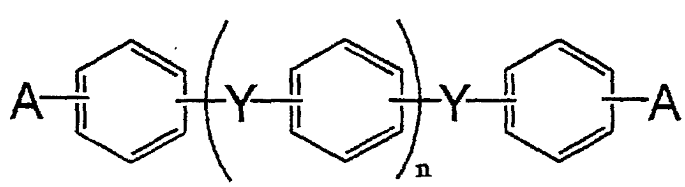 (2)

(wherein A represents $-NH_2-$ or -NCO, Y independently represents -C(=O)-, $-SO_2-$, -O-, -S-, $-(CH_2)_m-$, -NHCO-, $-C(CH_3)_2-$, $-C(CF_3)_2-$, -C(=O)O- or a single bond, and m and n each are an integer of 0 to 10).

**32.** The adhesive laminated film for covering a conductor wire for an accelerator quench heater according to claim 30, wherein said thermosetting resin comprises two or more epoxy groups in one molecule.

FIG. 1

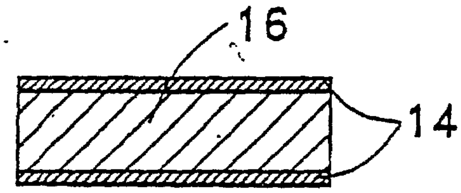


FIG. 2

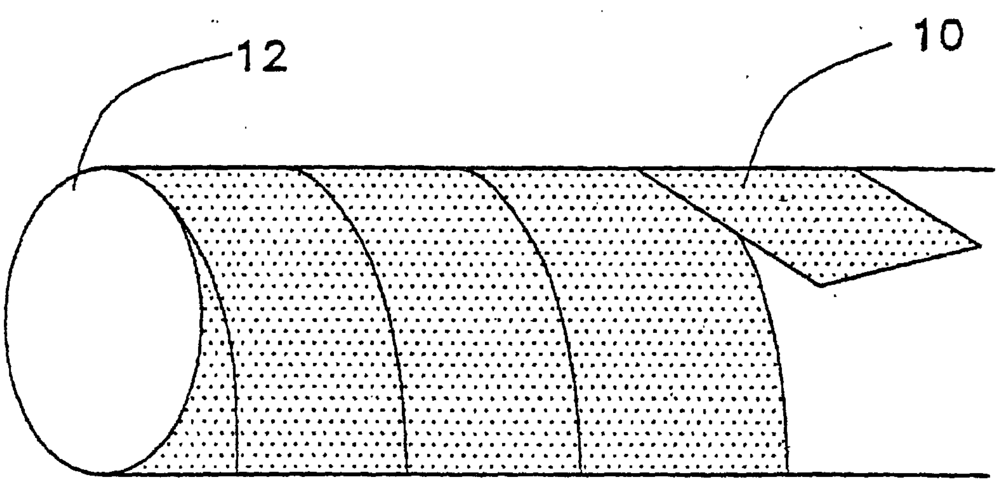

FIG. 3

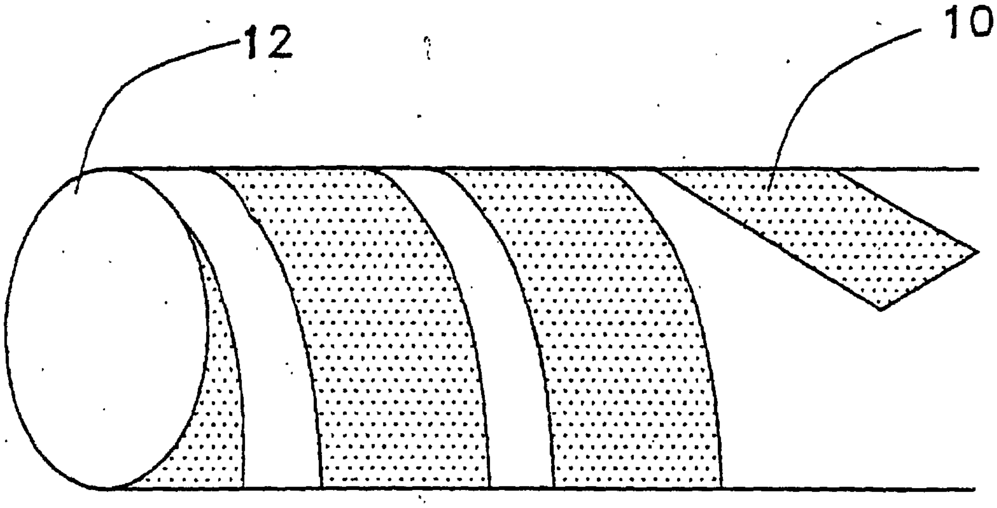


FIG. 4

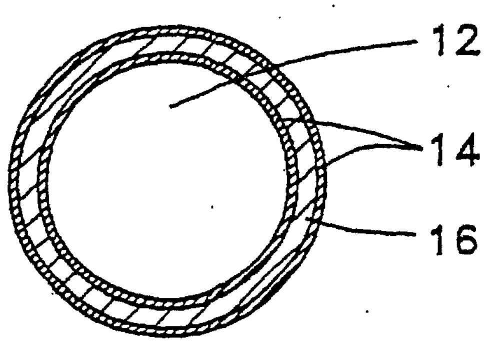

## INTERNATIONAL SEARCH REPORT

International application No.
PCT/JP00/07984

A. CLASSIFICATION OF SUBJECT MATTER
Int.Cl[7] C08G73/10

According to International Patent Classification (IPC) or to both national classification and IPC

B. FIELDS SEARCHED
Minimum documentation searched (classification system followed by classification symbols)
Int.Cl[7] C08G73/10

Documentation searched other than minimum documentation to the extent that such documents are included in the fields searched

Electronic data base consulted during the international search (name of data base and, where practicable, search terms used)
REGISTRY(STN),CA(STN)

C. DOCUMENTS CONSIDERED TO BE RELEVANT

| Category* | Citation of document, with indication, where appropriate, of the relevant passages | Relevant to claim No. |
|---|---|---|
| X<br>A | JP, 3-60182, A (Hitachi Chemical Co., Ltd.), 15 March, 1991 (15.03.91) (Family: none) | 1-3,6,8-11, 13-18,21-23<br>4-5,7,12, 19-20,24-32 |
| X<br>A | JP, 1-95155, A (MITSUBISHI KASEI CORP.), 13 April, 1989 (13.04.89) (Family: none) | 1-2<br>3-32 |
| X<br>A | JP, 61-141731, A (Ube Industries, Ltd.), 28 June, 1986 (28.06.86) (Family: none) | 1-2<br>3-32 |
| X<br>A | JP, 8-113646, A (Toyobo Co., Ltd.), 07 May, 1996 (07.05.96) (Family: none) | 1-2<br>3-32 |
| X<br>A | JP, 7-92452, A (Sumitomo Electric Industries, Ltd.), 07 April, 1995 (07.04.95) (Family: none) | 1-2<br>3-32 |
| P,X<br>P,Y<br>P,A | JP, 2001-11177, A (Kanegafuchi Chem. Ind. Co., Ltd.), 16 January, 2001 (16.01.01) (Family: none) | 1-3<br>6,8-11,13-15<br>4-5,7,12, 16-32 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 January, 2001 (26.01.01) | 13 February, 2001 (13.02.01) |
| Name and mailing address of the ISA/<br>Japanese Patent Office | Authorized officer |
| Facsimile No. | Telephone No. |

Form PCT/ISA/210 (second sheet) (July 1992)